# EUROPÄISCHE PATENTANMELDUNG

(11) **EP 1 394 171 A1**
(43) Veröffentlichungstag der Anmeldung: **03.03.2004**
(21) Anmeldenummer: 03017031.0
(22) Anmeldetag: 28.07.2003
(51) Int. Cl.: C07F 15/00, C09K 11/00

(54) **Mehrkernige Metallkomplexe als Phosphoreszenzemitter in elektrolumineszierenden Schichtanordnungen**

(30) Priorität: 09.08.2002 DE 10236538
(71) Anmelder: Bayer Aktiengesellschaft, 51368 Leverkusen (DE)
(72) Erfinder: Heuer, Helmut-Werner, Dr., 47829 Krefeld (DE); Wehrmann, Rolf, Dr., 47800 Krefeld (DE); Sautter, Armin, Dr., 47807 Krefeld (DE)

(57) **Zusammenfassung**

Die vorliegende Erfindung betrifft mehrkernige Metallkomplexe, ein Verfahren zu deren Herstellung sowie deren Verwendung als Phosphoreszenzemitter in elektrolumineszierenden Schichtanordnungen.

## Beschreibung

Die vorliegende Erfindung betrifft mehrkernige Metallkomplexe, ein Verfahren zu deren Herstellung sowie deren Verwendung als Phosphoreszenzemitter in elektrolumineszierenden Schichtanordnungen.

Elektrolumineszierende Schichtanordnungen, im Folgenden auch als elektrolumineszierende Anordnungen oder EL-Anordnungen bezeichnet, sind vielseitig einsetzbar, beispielsweise in optoelektronischen Anwendungen, wie z.B. Leuchtdioden (LEDs = light emitting diodes), sowie bei der Herstellung von Bildschirmen oder Displays. Neuerdings steigt das Interesse an emissiven Displays und Anzeigevorrichtungen, besonders unter Ausnutzung der Elektrophosphoreszenz zur Erhöhung der Lichtausbeute (s. Baldo et al., Appl. Phys. Lett., Vol 75, No 1, 4, 1999; WO 00/70 655 A2), WO 01/415 12 A1).

Die Lichtemission in organischen Leuchtdioden erfolgt normalerweise bevorzugt durch Fluoreszenzprozesse. Die Elektrolumineszenz (EL)-Quanteneffizienz einer Anordnung mit einem fluoreszierenden Emitter ist allerdings durch das geringe theoretische Verhältnis von Singulett- (25 %) zu Triplett-Excitonen (75 %), die durch Elektron-Loch Rekombination gebildet werden, limitiert, da die Lichtemission nur aus angeregten Singulettzuständen erfolgt. Triplett-basierte Emission von Licht ist unter dem Begriff Phosphoreszenz bekannt (WO 00/70 655 A2). Der Vorteil von phosphoreszierenden Emittern ist, dass sowohl die Singulett- als auch die Triplettzustände zur Lichtemission beitragen, d.h. die interne Quanteneffizienz kann bis zu 100 % erreichen, da alle Excitonen zur Lichtemission genutzt werden können.

Die organischen Elektrolumineszenz (EL)-Anordnungen enthalten in der Regel neben der Licht-emittierenden Schicht eine oder mehrere Schichten aus organischen Ladungstransportverbindungen. Der prinzipielle Aufbau in der Reihenfolge der Schichten ist wie folgt:
1 Träger, Substrat
2 Basiselektrode
3 Löcher-injizierende Schicht
4 Löchertransportierende Schicht (= lochleitende Schicht)
5 Lichtemittierende Schicht
6 Löcherblockierende Schicht
7 Elektronen-transportierende Schicht
8 Elektronen-injizierende Schicht
9 Topelektrode
10 Kontakte
11 Umhüllung, Verkapselung.

Die Begriffe löcher- oder lochtransportierend sowie lochleitend sind in ihrer Bedeutung im Folgenden als gleich zu betrachten.

Die Schichten 1 bis 10 stellen die elektrolumineszierende Anordnung dar.
Die Schichten 3 bis 8 stellen das elektrolumineszierende Element dar.

Dieser Aufbau beschreibt den allgemeinsten Fall und kann vereinfacht werden, indem einzelne Schichten weggelassen werden, so dass eine Schicht mehrere Aufgaben übernimmt. Im einfachsten Fall besteht eine EL-Anordnung aus zwei Elektroden, zwischen denen sich eine organische Schicht befindet, die alle Funktionen - inklusive der Emission von Licht - erfüllt.

Der Aufbau von Mehrschichtsystemen in LEDs kann durch Aufdampfverfahren (engl.: "Chemical Vapour deposition", CVD), bei denen die Schichten sukzessive aus der Gasphase aufgebracht werden, oder durch Gießverfahren erfolgen. Die Aufdampfverfahren werden in Verbindung mit der Lochmaskentechnik zur Fabrikation von strukturierten LEDs benutzt, die als Emitter organische Moleküle benutzen. Gießverfahren sind aufgrund der höheren Prozessgeschwindigkeiten und der geringeren Menge an produziertem Ausschnssmaterial und der damit verbundenen Kostenersparnis generell bevorzugt. Der Drucktechnik, insbesondere der Tintenstrahltechnik, zum Strukturieren von polymeren Emittern wird momentan große Aufinerksamkeit gewidmet (Yang et al. *Appl. Phys. Lett.* **1998**, 72 (21), 2660; WO 99/54936).

Die Effizienz der elektrolumineszierenden Anordnungen konnte durch Einbau von phosphoreszierenden Dotierstoffen in eine Matrix in den vergangenen Jahren deutlich gesteigert werden. Für die Verwendung des grün phosphoreszierenden Bis(2-phenylpyridin)iridium(III)acetylacetonat [(ppy)₂Ir(acac)] Komplexes als Dotierstoff in EL-Anordnungen wurden externe EL-Effizienzen von 19 % bestimmt (C. Adachi et al., *J. Appl. Phys.* **2001**, *90*, 5048). Allerdings konnten derartig hohe Effizienzen bislang nur in Mehrschichtanordnungen, die durch aufwendige Aufdampfverfahren hergestellt wurden, realisiert werden. Gründe hierfür sind die nur mäßige Löslichkeit der verwendeten Iridiumkomplexe und deren starke Tendenz zur Rekristallisation, die für eine Applikation aus Lösung ungünstig ist. Wünschenswert wäre die viel einfachere und etablierte Verarbeitung aus Lösung, beispielsweise mittels Spin-Coating, Casting- oder Ink-Jet-Verfahren. In WO 01/41512 A1 werden Komplexe als Phosphoreszenz-Dotierstoffe beschrieben, die jedoch eine nicht ausreichende Löslichkeit für ein Ink-Jet-Verfahren zeigen.

Kürzlich wurden lösliche niedermolekulare Iridium-Komplexe mit sterisch anspruchsvollen Fluorenyl-Pyridin bzw. Fluorenyl-Phenylpyridinliganden synthetisiert, die zwar einer Applikation aus Lösung zugänglich sind, jedoch nur sehr geringe EL-Effizienzen von 0,1% in "single layer" (Einschicht) EL-Anordnungen aufweisen (J. C. Ostrowski et al, *Chem. Commun.* **2002**, 784-785). Durch die Verwendung dieser Iridiumkomplexe als Dotierstoffe in einer Matrix konnten die Effizienzen auf bis zu 8,8 % gesteigert werden (X. Gong et al., *Adv. Mater.* **2002**, *14*(8), 581-585). Auch in P.L. Burn et al., Appl. Phys. Lett. 2002, 80 (15), 2645-2647 und Y. Cao et al., Appl. Phys. Lett. 2002, 80 (12), 2045-2047 werden Iridiumkomplexe beschrieben, welche durch Substitution am Liganden eine verbesserte Löslichkeit aufweisen. Diese Verbindungen konnten zusammen mit einer Polymermatrix aus Lösung durch spincoating appliziert werden. Ein großer Nachteil ist bei all diesen Verbindungen jedoch der enorme Syntheseaufwand bei der Herstellung der substituierten Liganden und die nachfolgende Umsetzung zu den Iridiumkomplexen, die im Allgemeinen nur in geringen Ausbeuten (30-50 %) und unter drastischen Bedingungen (150-200°C) erfolgt.

Die Aufgabe der vorliegenden Erfindung war daher die Bereitstellung neuer Verbindungen, welche als Phosphoreszenz-Emitter geeignet, einfach herstellbar und einer Applikation aus Lösung zugänglich sind und die vorangehend genannten Nachteile beispielweise einer aufwendigen Ligandensynthese und der starken Neigung zur Rekristallisation nicht zeigen.

Gegenstand der vorliegenden Erfindung sind mehrkernige Metallkomplexe der allgemeinen Formel (I),

(LₘMe-H_{L})ₙX_{L} (I)

worin
- Me: für ein Übergangsmetall, bevorzugt für ein Übergangsmetall der 6. bis 8. Nebengruppe, der Lanthanoid- oder Actinoidgruppe, besonders bevorzugt für Platin(II) oder Iridium(III), steht,
- L: für einen bidentalen chelatbildenden Liganden steht,
- H_{L}: für einen bidentalen chelatbildenden Liganden steht, der das Übergangsmetall Me chelatartig komplexiert und zusätzlich an einen Linker X_{L} gebunden ist,
- X_{L}: für einen n-funktionellen Linker steht und an n Hilfsliganden H_{L} kovalent gebunden ist,
- n: für eine ganze Zahl von 2 bis 6, bevorzugt für 2 oder 3, steht und
- m: für eine ganze Zahl von 1 bis 3, bevorzugt für 1 oder 2, steht.

Mehrkernige Metallkomplexe der allgemeinen Formel (I) können im Rahmen der Erfindung beispielsweise Metallkomplexe der folgenden Formeln I-1 bis I-5 sein, 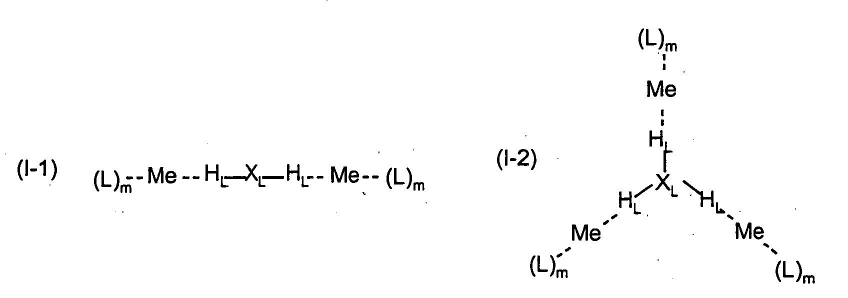 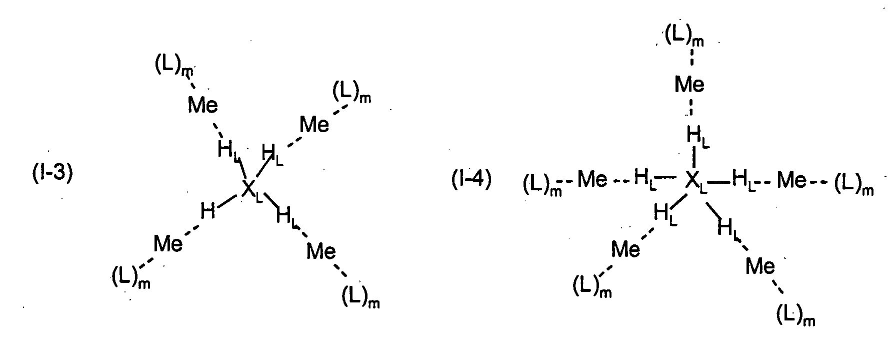 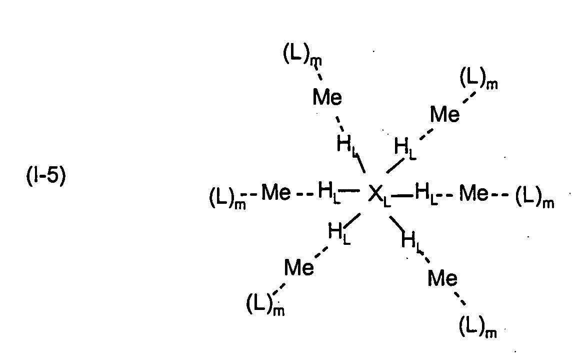 wobei
- Me, L, H_{L}, X_{L} und m: die oben genannte Bedeutung haben.

Bevorzugt Gegenstand der Erfindung sind mehrkernige Metallkomplexe der allgemeinen Formel (I), worin
- L: für einen bidentalen chelatbildenden Liganden ausgewählt aus den allgemeinen Formeln (II) bis (XIX) steht, 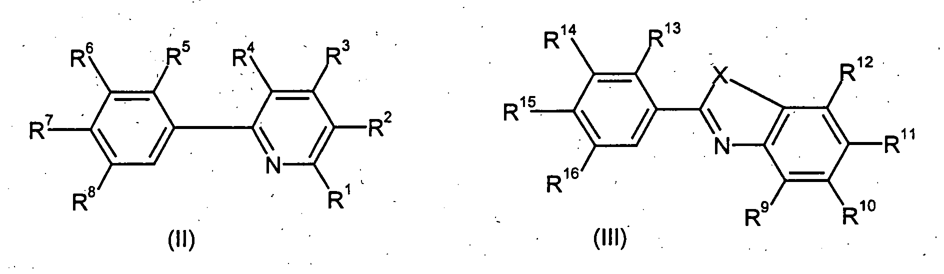 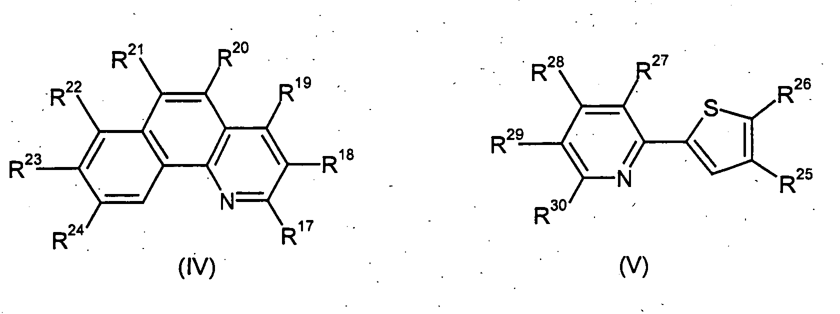 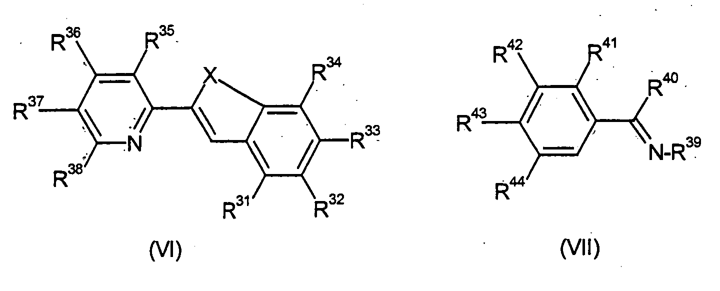 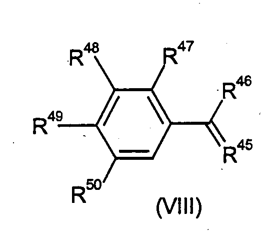 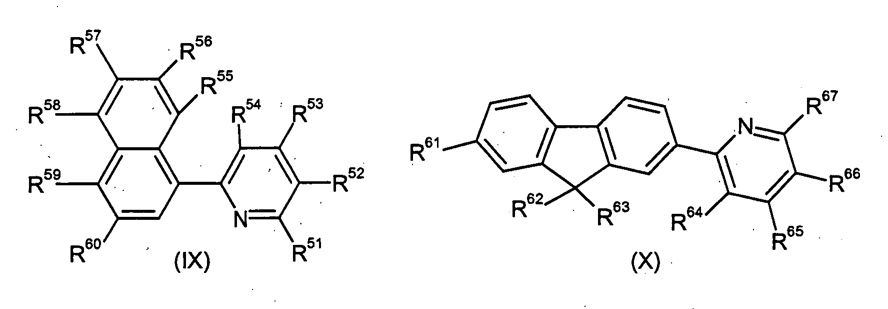 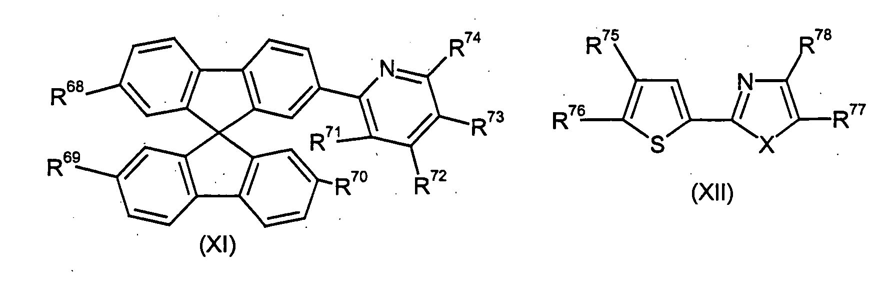 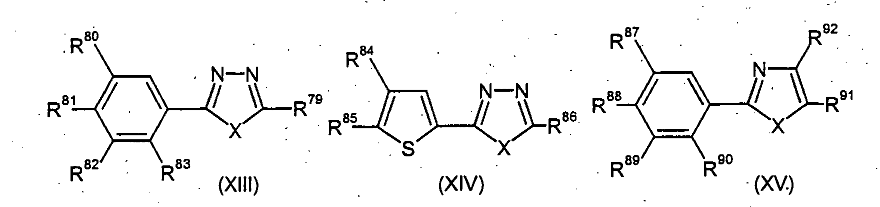 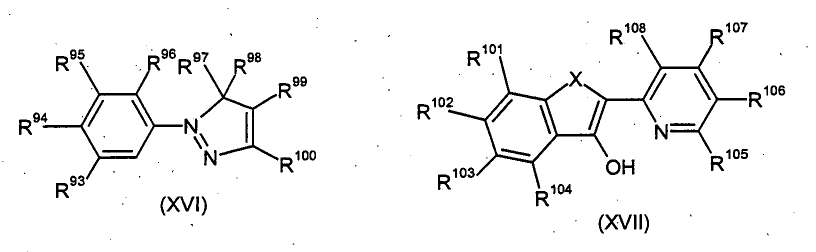 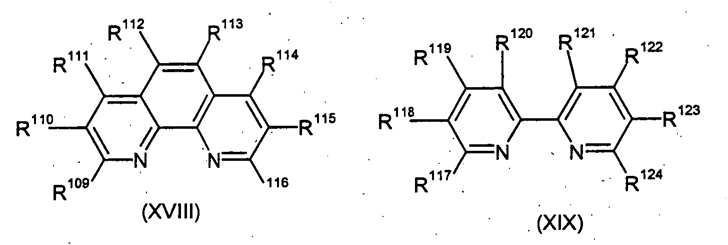 wobei
X für Sauerstoff, Schwefel, N-Alkyl oder N-H steht,
R¹-R¹²⁴ gleich oder verschieden sind und unabhängig voneinander für H, F, CF₃, eine lineare oder verzweigte C₁-C₂₂-Alkylgruppe, eine lineare oder verzweigte C₁-C₂₂-Alkoxygruppe, eine gegebenenfalls C₁-C₃₀-alkylsubstituierte C₅-C₂₀-Aryleinheit und/oder eine gegebenenfalls C₁-C₃₀-alkylsubstituierte Heteroaryleinheit mit 5 bis 9 Ring-C-Atomen und 1 bis 3 Ringheteroatomen aus der Gruppe Stickstoff, Sauerstoff und Schwefel stehen.
H_{L} für einen bidentalen chelatbildenden Liganden ausgewählt aus den allgemeinen Formel (XX) bis (XXX) steht, das Übergangsmetall Me chelatartig komplexiert und über die mit * gekennzeichnete Verknüpfungsstelle an den Linker X_{L} gebunden ist, 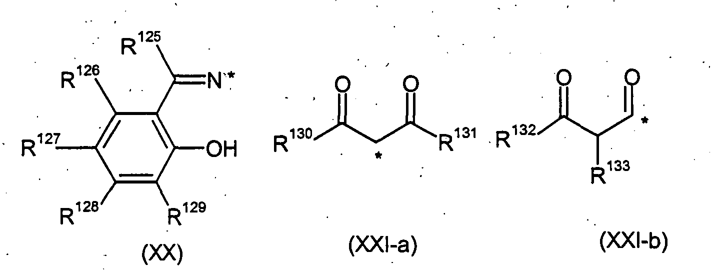 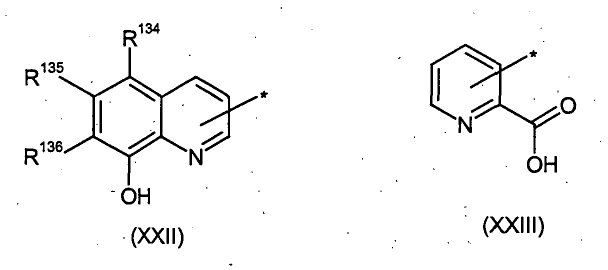 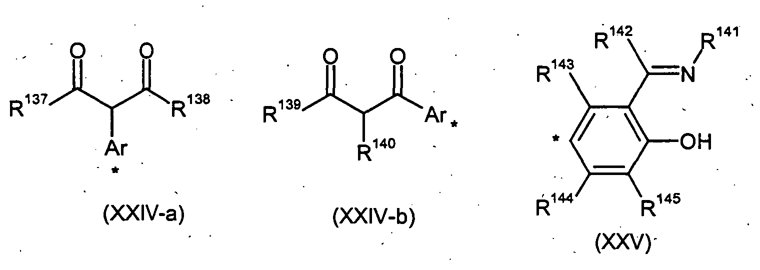 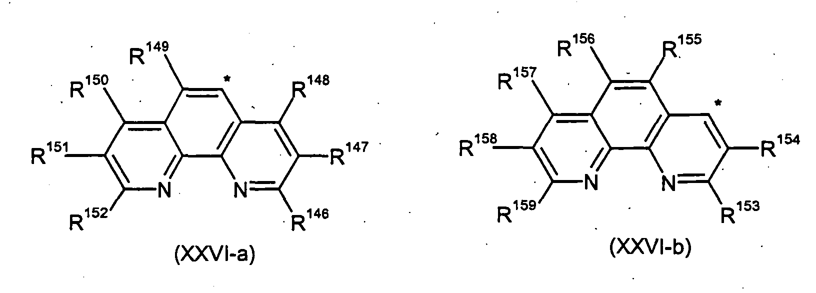 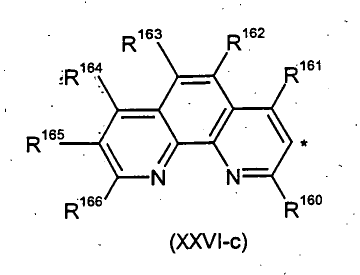 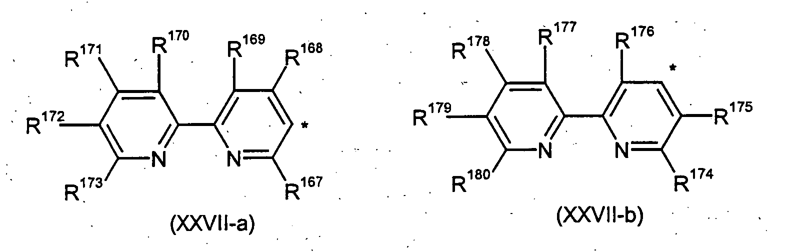 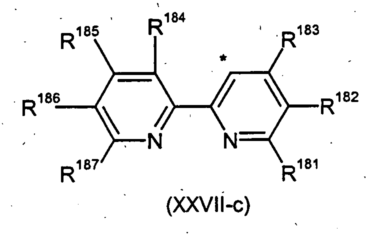 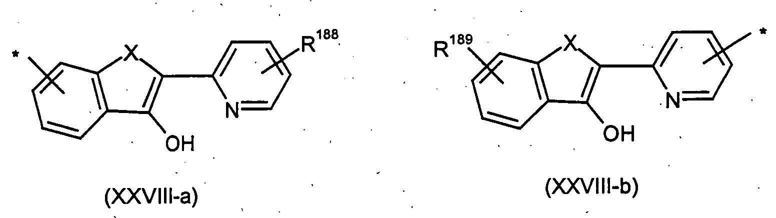 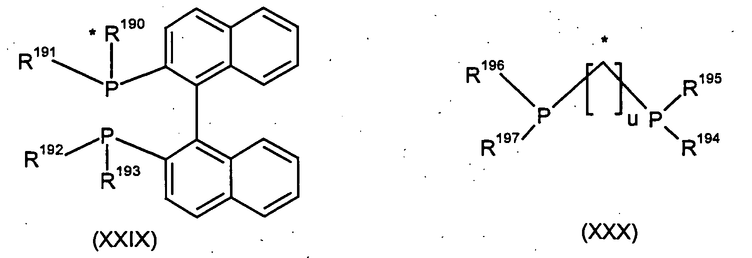 und
- X: für Sauerstoff, Schwefel oder N-Alkyl oder N-H steht,
- u: für eine ganze Zahl von 1 bis 6 steht,
- Ar: für gegebenenfalls durch eine lineare oder verzweigte C₁-C₃₀ Alkyl- oder C₁-C₃₀ Alkoxygruppe, F, Cyano oder CF₃- substituiertes Phenyl, Thienyl, Fluroenyl, Pyrrol, Carbazol oder 1,4-Phenylen-vinylen steht,
- R¹²⁵-R¹⁹⁷: gleich oder verschieden sind und unabhängig voneinander für H, F, CF₃, eine lineare oder verzweigte C₁-C₂₂-Alkylgruppe, eine lineare oder verzweigte C₁-C₂₂-Alkoxygruppe, eine gegebenenfalls C₁-C₃₀-alkylsubstituierte C₅-C₂₀-Aryleinheit und/oder eine gegebenenfalls C₁-C₃₀-alkylsubstituierte Heteroaryleinheit mit 5 bis 9 Ring-C-Atomen und 1 bis 3 Ringheteroatomen aus der Gruppe Stickstoff, Sauerstoff und Schwefel stehen und
- Me, X_{L} und n: die in Anspruch 1 genannte Bedeutung haben.

Besonders bevorzugt sind dies mehrkernige Metallkomplexe der allgemeinen Formel (I), worin
- X_{L}: ein n-funktioneller Linker ausgewählt aus den folgenden allgemeinen Formeln (XXXI) bis (XXXXVI) ist, 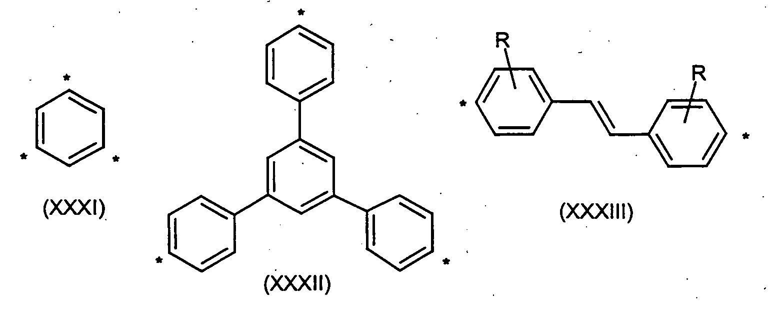 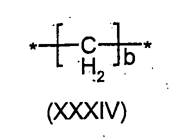 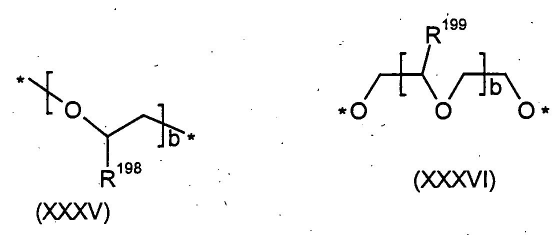 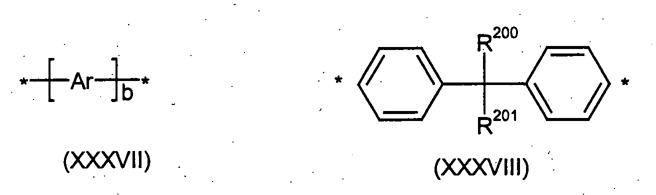 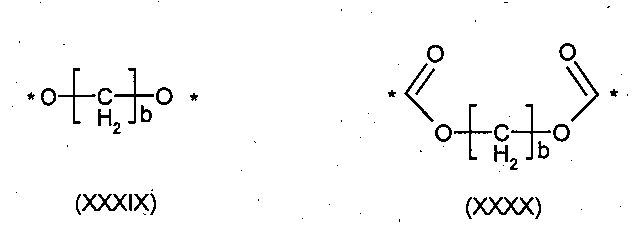 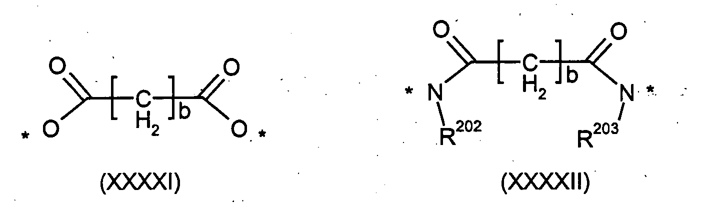 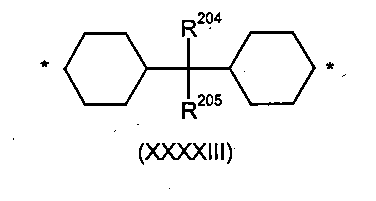 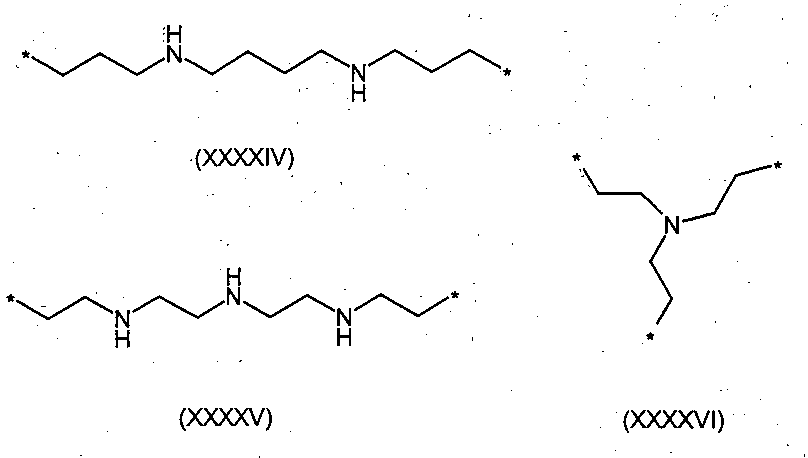 wobei
b für eine ganze Zahl von 2 bis 300, bevorzugt 2 bis 100,
R¹⁹⁸ - R²⁰⁵ gleich oder verschieden sind und unabhängig voneinander für H oder lineares oder verzweigtes C₁-C₃₀-Alkyl stehen, und
Ar¹ für gegebenenfalls durch eine lineare oder verzweigte C₁-C₃₀-Alkyl- oder C₁-C₃₀-Alkoxygruppe, F, Cyano oder CF₃- substituiertes Phenyl, Thienyl, Fluroenyl, Pyrrol, Carbazol oder 1,4-Phenylen-vinylen steht, oder
- X_{L}: für α,ω-Alkyl, α,ω-Oligoethylenoxy, α,ω-Arylen, α,ω-Oligoester, α,ω-Oligoether, α,ω-Dioxyalkyl, α,ω-Dioxy-Polyester, α,ω-Dioxy-Oligoester oder die entsprechenden Polyacrylat-, Polyester-, Polyether-Polyole (Desmophene®, Firma Bayer AG, Leverkusen), oder für α,ω- lineare und verzweigte aliphatische Polycarbonat-Polyester steht,
wobei X_{L} an H_{L} gegebenenfalls über eine Ester-, Ether-, Amid-, Amin-, Imin-, Carbonat- oder Urethan-Gruppe angeknüpft ist.

Das Prafix Oligo- in den vorangehend aufgeführten Linkern X_{L} steht im Rahmen der Erfindung für zwei bis 50 Wiederholungseinheiten. Der Übergang von Oligo- zu Poly- ist als fließend zu betrachten, so dass das Präfix Poly- in den vorangehend aufgeführten Linkern X_{L} im Rahmen der Erfindung für zwei und mehr Wiederholungseinheiten steht.

Über die mit * gekennzeichneten Verknüpfungsstellen sind die Linker X_{L} an die Hilfsliganden H_{L} gebunden. An diesen Stellen muß gegebenenfalls H aus den aufgeführten allgemeinen Formeln abstrahiert werden.

Gegebenenfalls kann zur Bereitstellung der zur chelatartigen Komplexierung der Metallzentren Me notwendigen Koordinationsstellen die Abspaltung von Protonen an den oben aufgeführten Hifsliganden H_{L} erfolgen. Die verbleibenden Strukturen werden dann in den allgemeinen Formeln der vorliegenden Anmeldung ebenfalls als H_{L} bezeichnet.

Ganz besonders bevorzugt Gegenstand der vorliegenden Erfindung sind mehrkernige Metallkomplexe ausgewählt aus den allgemeinen Strukturen (Ia) bis (Ih) 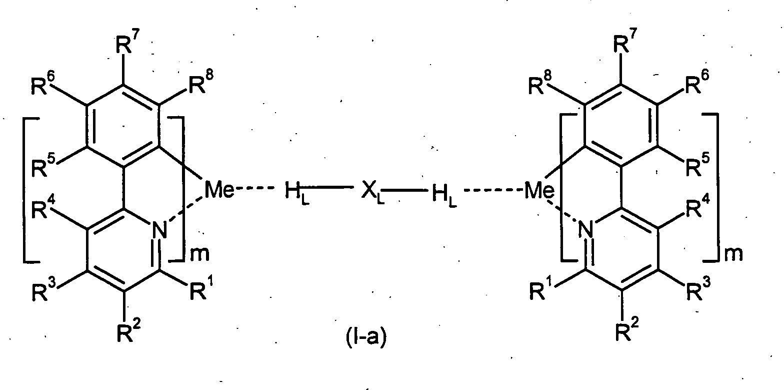 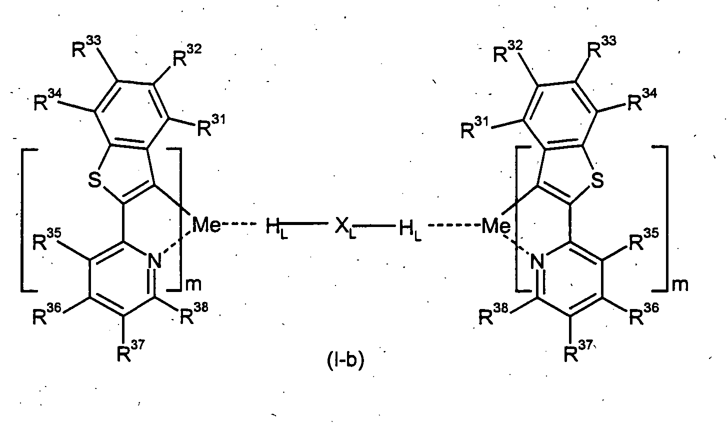 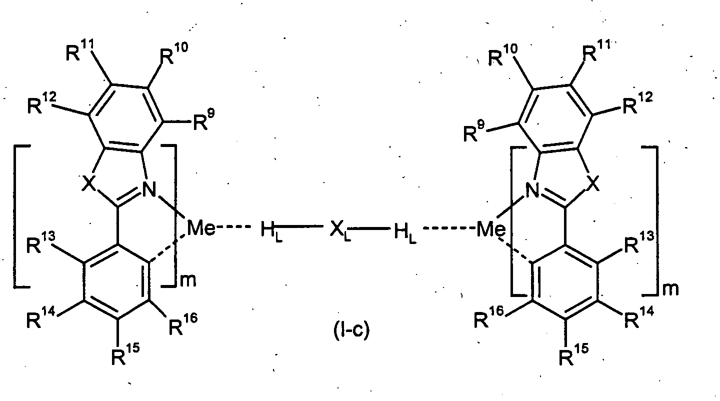 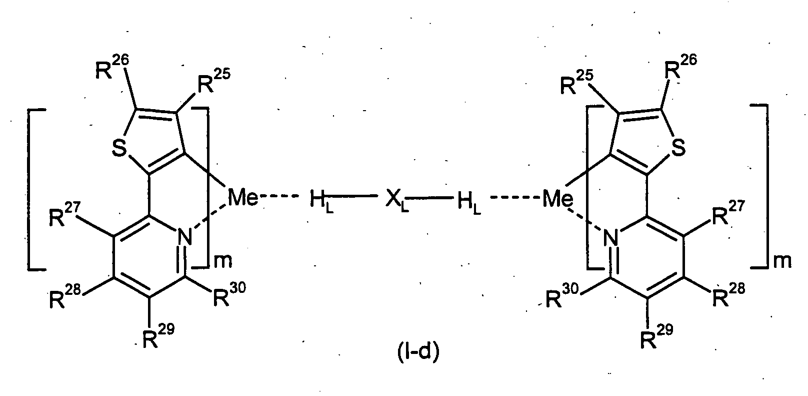 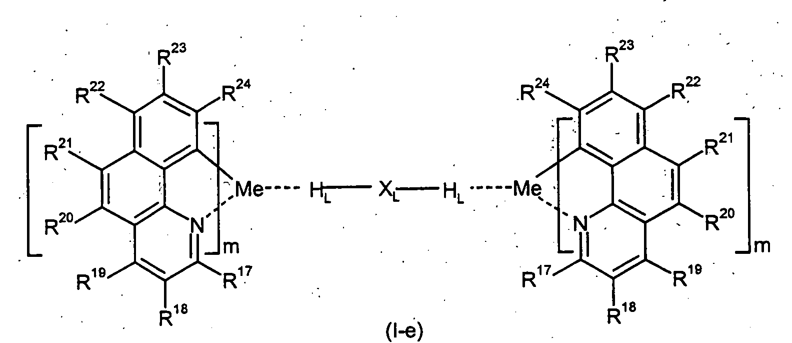 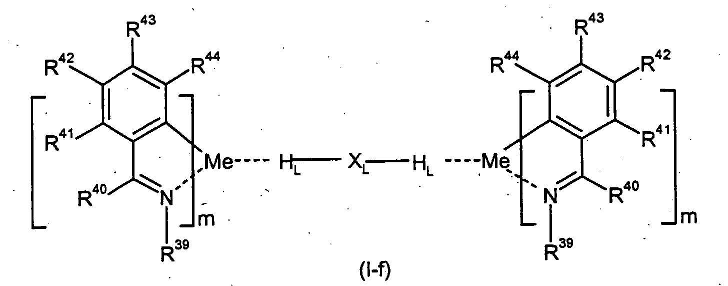 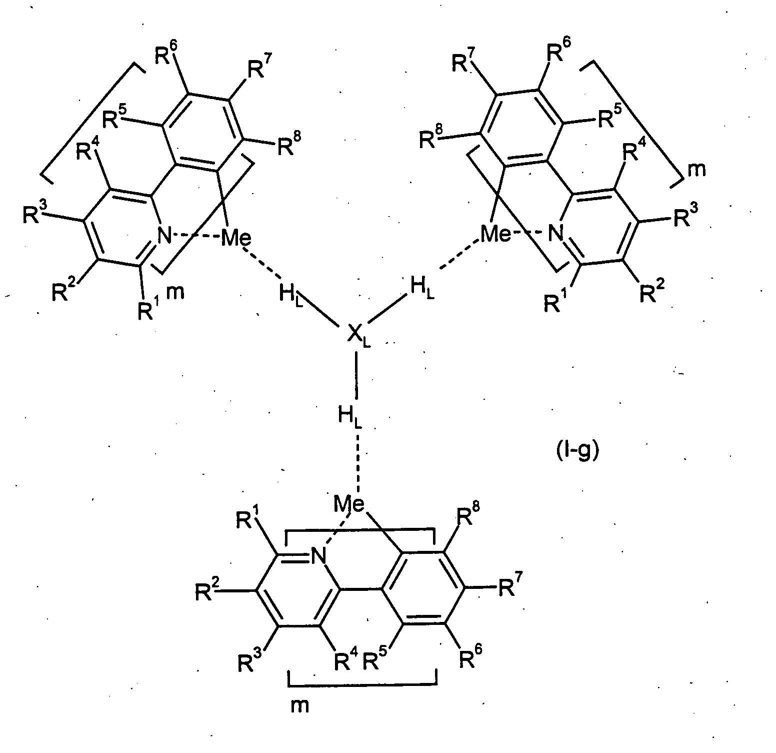 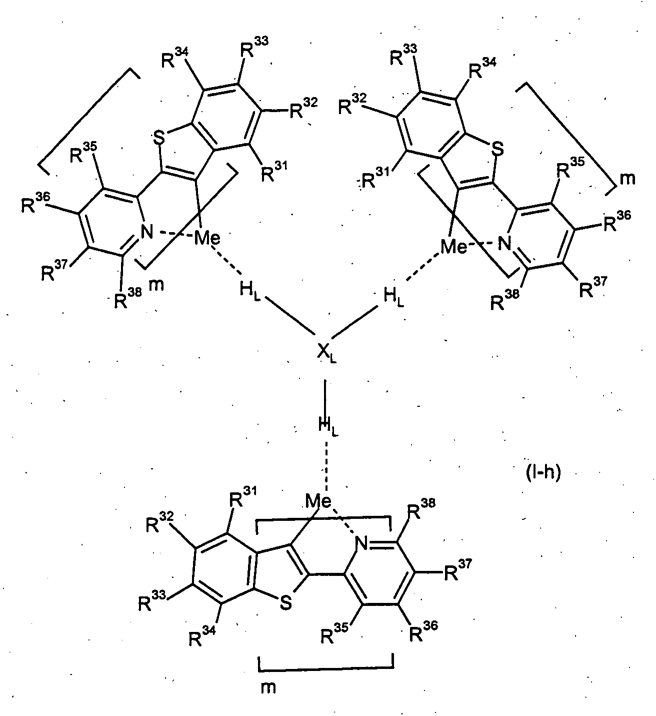 wobei
- Me: für Platin(II) oder Iridium(III) steht,
- m: für 1 oder 2 steht und
- X, R¹ - R⁴⁴, H_{L} und X_{L}: die oben genannte Bedeutung haben.

In bevorzugten Ausführungsformen der vorliegenden Erfindung sind dies die folgenden Verbindungen:

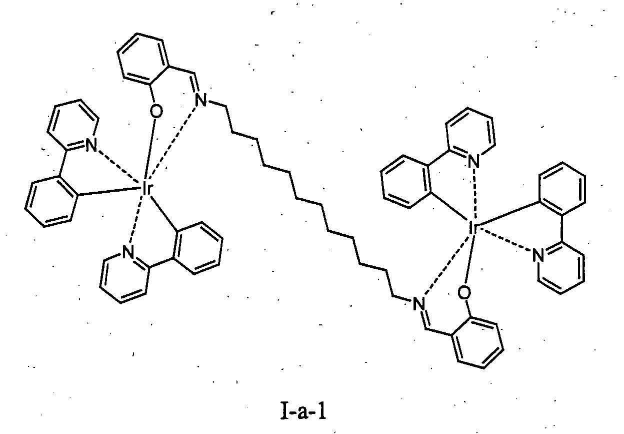

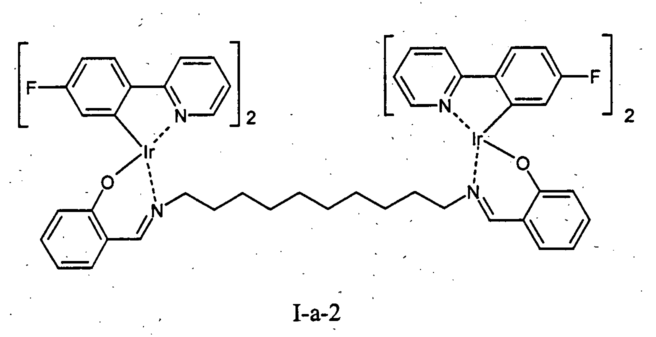

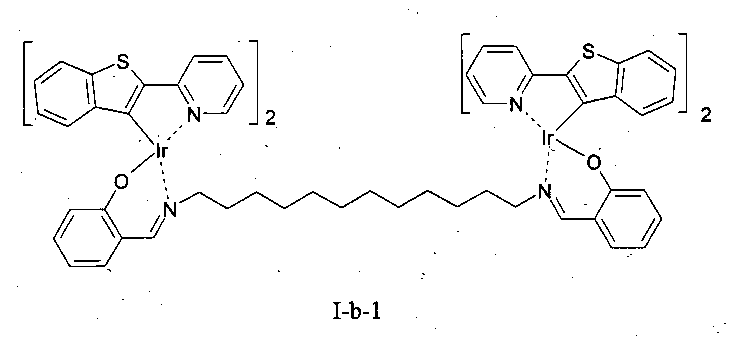

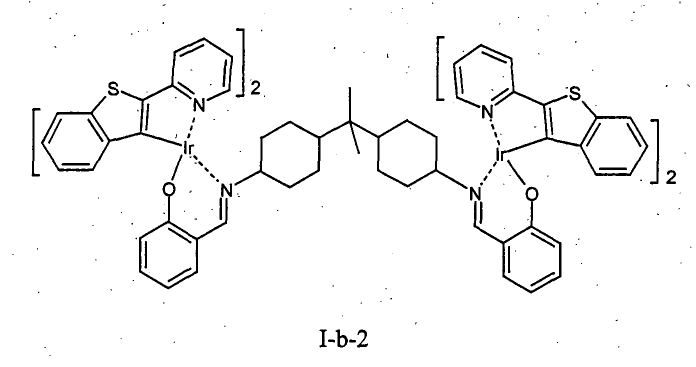

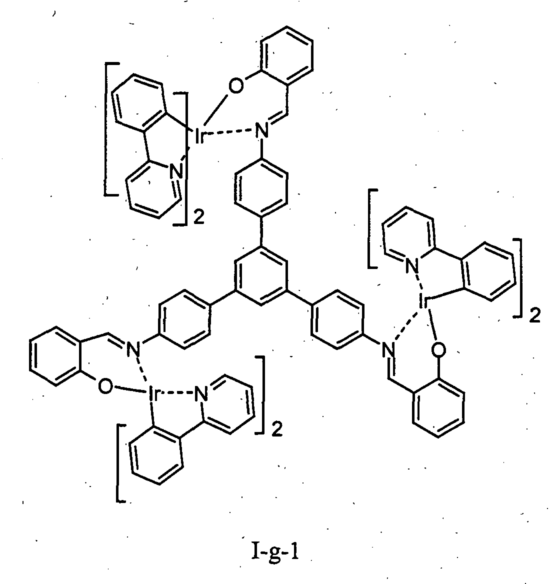

Überraschend wurde gefunden, dass mehrkernige phosphoreszierende Metallkomplexe eine intensive Phosphoreszenz zeigen. Die in der Literatur bekannten und gut untersuchten chloroverbrückten Iridium-Dimere L₂Ir(µ-Cl)₂IrL₂ zeigen bei Raumtemperatur praktisch keine Phosphoreszenz (S. Lamansky et al., Inorg. Chem. 2001, 40, 1704). Werden die beiden Iridiumzentren jedoch erfindungsgemäß über einen geeigneten n-funktionellen Liganden X_{L}(H_{L})ₙ anstatt über Chloratome verbrückt, so findet man überraschend intensive Phosphoreszenzeigenschaften.

Die erfindungsgemäßen mehrkernigen Metallkomplexe lassen sich auf einfache Weise aus den literaturbekannten geeigneten zweikernigen Metallkomplexen der allgemeinen Formel (A), 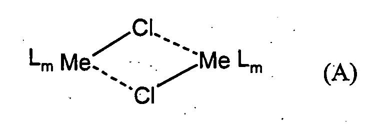 durch Ligandenaustausch mit einem n-funktionellen Liganden X_{L}(H_{L})ₙ, enthaltend n jeweils bidentale Hilfsliganden H_{L}, herstellen.

Weiterhin Gegenstand der vorliegenden Erfindung ist daher ein Verfahren zur Herstellung der erfindungsgemäßen mehrkernigen Metallkomplexe, dadurch gekennzeichnet, dass Verbindungen der allgemeinen Formel (A) 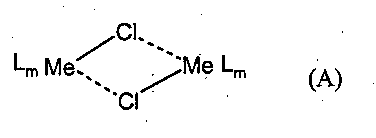 mit einem n-funktionellen Liganden X_{L}(H_{L})ₙ, enthaltend n jeweils bidentale Hilfsliganden H_{L}, unter Zusatz einer Base umgesetzt werden,
wobei m, Me, L, X_{L}, H_{L} und n die oben genannte Bedeutung haben.

Bevorzugt werden im erfindungsgemäßen Verfahren als Verbindungen der Formel (A) Verbindungen der allgemeinen Formeln L₂Ir(µ-Cl)₂IrL₂ oder LPt(µ-Cl)₂PtL sowie als Basen Na₂CO₃, K₂CO₃ oder Natriummethanolat eingesetzt. Bevorzugte Liganden X_{L}(H_{L})ₙ sind alle Kombinationen aus den vorangehend für H_{L} aufgeführten allgemeinen Formeln (XX) bis (XXX) mit den vorangehend für X_{L} aufgeführten allgemeinen Formeln (XXXI) bis (XXXXVI) oder den für X_{L} weiterhin aufgeführten, nicht durch Formeln dargestellten, Strukturen. Besonders bevorzugte Liganden X_{L}(H_{L})ₙ sind N,N'-bis(salicyliden)diamine und N,N',N"-tris(salicyliden)triamine, ganz besonders bevorzugt N,N',N"-tris(salicyliden)aryltriamine oder N,N',N"-tris(salicyliden)alkyltriamine oder N,N'-bis(salicyliden)alkyldiamine oder N,N'-bis(salicyliden)aryldiamine, wobei Alkyl beispielsweise für gegebenenfalls substituiertes C₁-C₂₀-Alkyl, beispielsweise Decyl, Dodecyl, Hexadecyl oder Octadecyl, stehen und gegebenenfalls Ethylenoxy-Einheiten oder sekundäre oder tertiäre Amineinheiten enthalten kann, und Aryl für gegebenenfalls substituiertes C₁-C₃₀-Aryl, beispielsweise für 2,2-Diphenylpropan, 2,2-Diphenylmethan, 2,2-Dicyclohexylpropan, Phenyl, 1,3,5-Triphenylbenzol, Fluoren oder Biphenyl, stehen kann.

Die Reaktion ist für einkernige Iridiumkomplexe in WO 01/41512 A1 beschrieben und lässt sich auf mehrkernige Komplexe übertragen. Sie kann in gängigen organischen Lösungsmitteln wie beispielsweise chlorierten Kohlenwasserstoffen, Alkoholen, Ethern, Aromaten, halogenierten Aromaten, bevorzugt 1,2-Dichlorethan, Chloroform, Ethanol, Methanol, Ethoxyethanol, Methoxyethanol, Glycerin, sowie Mischungen aus diesen, durchgeführt werden.

Die Liganden X_{L}(H_{L})ₙ sind teilweise kommerziell verfügbar oder nach gängigen Verfahren herstellbar. Beispielsweise können die N,N'-bis(salicyliden)diamine aus den entsprechenden kommerziell verfügbaren Diaminen und Salicylaldehyd durch Kochen in Toluol oder Chloroform am Wasserabscheider, gegebenenfalls unter Zusatz katalytischer Mengen an Toluolsulfonsäure, hergestellt werden.

Überraschend wurde gefunden, dass die erfindungsgemäßen mehrkernigen Metallkomplexe sowohl hervorragende Phosphoreszenzeigenschaften besitzen als auch einer Applikation aus Lösung zugänglich sind. Gegenüber bekannten einkernigen Dotierstoffen weisen sie nicht nur den Vorteil der besseren Löslichkeit auf, sondern sind auch durch das erfindungsgemäße Verfahren deutlich einfacher zugänglich als viele der einleitend aufgeführten einkernigen Komplexe.

Aufgrund ihrer hervorragenden Phosphoreszenzeigenschaften eignen sich die erfindungsgemäßen mehrkernigen Metallkomplexe sehr gut als Phosphoreszenzemitter in lichtemittierenden Bauteilen. Die erfindungsgemäßen mehrkernigen Metallkomplexe zeigen einerseits Elektrophosphoreszenz, d.h. phosphoreszieren - beispielsweise im OLED - durch elektrische Anregung; sie können aber außerdem optisch zur Phosphoreszenz angeregt werden.

Weiterhin Gegenstand der vorliegenden Erfindung ist somit die Verwendung der erfindungsgemäßen mehrkernigen Metallkomplexe als Phosphoreszenzemitter in lichtemittierenden Bauteilen, beispielsweise organischen elektrolumineszierenden Anordnungen, Phosphoreszenzanzeigen, organische Leuchtdioden, Laseranwendungen etc..

Gegenüber einkernigen Metallkomplexen als Emittermaterialien besitzen die erfindungsgemäßen mehrkernigen Metallkomplexe diesbezüglich den Vorteil, dass Löschprozesse, die zum Absinken der externen Quanteneffizienz führen, reduziert werden. Diese treten bei niedermolekularen Emittern mit steigender Metall-Konzentration (lokaler Anhäufung) vermehrt durch Migrationsprozesse auf. In den erfindungsgemäßen mehrkernigen Metallkomplexen sind die Metallzentren durch die Verknüpfung über den Linker X_{L} einerseits in höherem Maße immobilisiert und andererseits in ausreichendem Abstand zueinander angeordnet, so dass sie migrationsstabiler sind.

Bestandteil lichtemittierender Bauteile ist eine elektro- oder photolumineszierende Schichtanordnung, auch als elektrolumineszierende (EL) oder photolumineszierende Anordnung bezeichnet. Bevorzugt werden die erfindungsgemäßen mehrkernigen Metallkomplexe als Phosphoreszenzemitter in elektrolumineszierenden Schichtanordnungen eingesetzt, deren prinzipieller Aufbau einleitend bereits beschrieben wurde.

Ebenfalls Gegenstand der vorliegenden Erfindung ist somit eine elektrolumineszierende Schichtanordnung enthaltend eine oder mehrere Schichten ausgewählt aus der Reihe der lochinjizierenden, lochleitenden, lichtemittierenden, löcherblockierenden, elektronentransportierenden oder elektroneninjizierenden Schichten, dadurch gekennzeichnet, dass die lichtemittierende Schicht die erfindungsgemäßen mehrkemigen Metallkomplexe als Phosphoreszenzemitter enthält. Weiterhin kann die elektrolumineszierende Schichtanordnung zwei oder mehrere Elektroden enthalten, von denen vorteilhafterweise wenigstens eine transparent ist, einen Träger oder ein Substrat, auf welches eine der Elektroden aufgebracht ist und welches ebenfalls vorteilhafterweise transparent ist, zwei Kontakte sowie eine Umhüllung oder Verkapselung. Zur Vereinfachung des Schichtaufbaus kann auch eine Schicht mehrere Funktionen übernehmen, so dass Schichten aus oben genannter Aufzählung weggelassen werden können.

Die lichtemittierende Schicht kann die erfindungsgemäßen mehrkernigen Metallkomplexe als schichtbildende Materialien ohne Zusätze oder aber als Dotierstoffe in einer Matrix eingebettet enthalten.

Bevorzugt Gegenstand der vorliegenden Erfindung ist eine elektrolumineszierende Schichtanordnung, worin die erfindungsgemäßen mehrkernigen Metallkomplexe als Dotierstoffe in eine niedermolekulare oder polymere Matrix eingebettet sind. Dies beinhaltet auch solche Matrizes, welche aus Gemischen von polymeren und niedermolekularen Komponenten aufgebaut sind.

Dabei können die erfindungsgemäßen mehrkernigen Metallkomplexe in der Matrix mit 0,1-bis 30 Gewichtsprozent, bevorzugt mit 1 bis 10 Gewichtsprozent, enthalten sein. Die Matrix kann, für den Fall, dass sie polymer ist, vorzugsweise auf Basis von Poly-*N*-vinylcarbazolen (PVK), Poly-2,7-fluorenen (PF), Poly-*para*-Phenylenen (PPP), oder einer Mischung aus wenigstens einem dieser Polymeren und 2-(4-biphenylyl)-5-(4-tert-butylphenyl)-1,3,4-oxadiazol (PBD) aufgebaut sein. Die Matrix kann, für den Fall, dass sie niedermolekular ist vorzugsweise aus 4,4'-N,N'-dicarbazolbiphenyl (CBP), oder aus einem im Folgenden beschriebenen lochleitenden Material auf Basis von aromatischen tertiären Aminen aufgebaut ist. Sie kann auch aus einer Mischung dieser Verbindungen mit 2-(4-biphenylyl)-5-(4-tert-butylphenyl)-1,3,4-oxadiazol (PBD) aufgebäut sein.

Alle vorangehend beschriebenen elektrolumineszierenden Schichtanordnungen, deren lichtemittierende Schicht die erfindungsgemäßen mehrkernigen Metallkomplexe als Phosphoreszenzemitter enthält, werden im Folgenden als erfindungsgemäße elektrolumineszierende Schichtanordnungen bezeichnet und bevorzugte Ausführungsformen werden beschrieben.

In einer bevorzugten Ausführungsform enthält die erfindungsgemäße elektrolumineszierende Schichtanordnung eine löcherblockierende Schicht, welche aus 2,9-dimethyl-4,7-diphenyl-[1,10]phenanthrolin (BCP, Bathocuproin), Bis(2-methyl-8-hydroxyquinolinato)gallium-chlorid (Ga(qa)₂Cl), Ga(qa)₂F, Ga(qa)₂-O-Ga(qa)₂ oder 3-(4-Biphenylyl)-4-phenyl-5-tert-butyl-phenyl-1,2,4-triazol (TAZ) besteht. 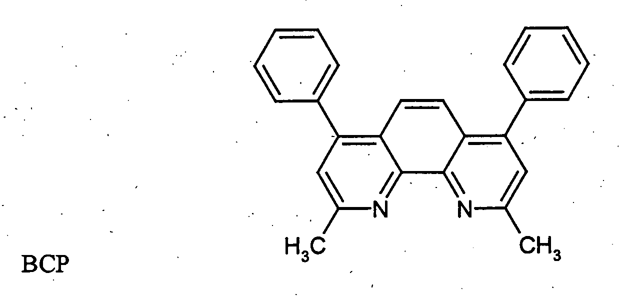 BCP und TAZ sind käuflich zu erwerben. Ga(qa)₂Cl, Ga(qa)₂F und Ga(qa)₂-O-Ga(qa)₂ sind in Elschner et al., Adv. Mater. 2001, 13, 1811-1814 beschrieben.

In einer weiteren bevorzugten Ausführungsform enthält die erfindungsgemäße elektrolumineszierende Schichtanordnung eine lochinjizierende Schicht, welche ein kationisches Polythiophen der allgemeinen Formel (B) enthält, 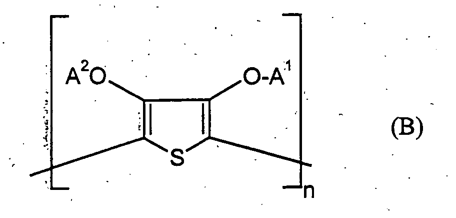 worin
- A¹ und A²: unabhängig voneinander für gegebenenfalls substituiertes (C₁-C₁₈)-Alkyl stehen oder zusammen gegebenenfalls substituiertes (C₁-C₁₈)-Alkylen bilden, und
- n: für eine ganze Zahl von 2 bis 10 000, vorzugsweise 3 bis 5 000 steht.

Dabei bezieht sich "kationisches" Polythiophen nur auf die Ladungen, die auf der Polythiophenhauptkette sitzen. Nicht berücksichtigt sind dabei solche Ladungen, die sich gegebenenfalls an den Substituenten A¹ oder A² befinden.

Besonders bevorzugte kationische Polythiophene sind aus Struktureinheiten der Formel (Ba) oder (Bb) aufgebaut 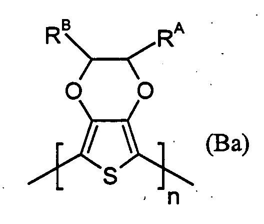 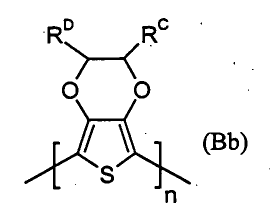 worin
- R^{A} und R^{B}: unabhängig voneinander für Wasserstoff, gegebenenfalls substituiertes (C₁-C₁₈)-Alkyl, vorzugsweise (C₁-C₁₀)-, insbesondere (C₁-C₆)-Alkyl, gegebenenfalls substituiertes (C₂-C₁₂)-Alkenyl, vorzugsweise (C₂-C₈)-Alkenyl, gegebenenfalls substituiertes (C₃-C₇)-Cycloalkyl, vorzugsweise Cyclopentyl, Cyclohexyl, gegebenenfalls substituiertes (C₇-C₁₅)-Aralkyl, vorzugsweise Phenyl-(C₁-C₄)-alkyl, gegebenenfalls substituiertes (C₆-C₁₀)-Aryl, vorzugsweise Phenyl, Naphthyl, gegebenenfalls substituiertes (C₁-C₁₈)-Alkyloxy, vorzugsweise (C₁-C₁₀)-Alkyloxy, beispielsweise Methoxy, Ethoxy, n- oder iso-Propoxy, oder gegebenenfalls substituierten (C₂-C₁₈)-Alkyloxyester steht und
- R^{C} und R^{D}: unabhängig voneinander für Wasserstoff, aber nicht beide gleichzeitig, mit mindestens einer Sulfonatgruppe substituiertes (C₁-C₁₈)-Alkyl, vorzugsweise (C₁-C₁₀)-, insbesondere (C₁-C₆)-Alkyl, mit mindestens einer Sulfonatgruppe substituiertes (C₂-C₁₂)-Alkenyl, vorzugsweise (C₂-C₈)-Alkenyl, mit mindestens einer Sulfonatgruppe substituiertes (C₃-C₇)-Cycloalkyl, vorzugsweise Cyclopentyl, Cyclohexyl, mit mindestens einer Sulfonatgruppe substituiertes (C₇-C₁₅)-Aralkyl, vorzugsweise Phenyl-(C₁-C₄)-alkyl, mit mindestens einer Sulfonatgruppe substituiertes (C₆-C₁₀)-Aryl, vorzugsweise Phenyl, Naphthyl, mit mindestens einer Sulfonatgruppe substituiertes (C₁-C₁₈)-Alkyloxy, vorzugsweise (C₁-C₁₀)-Alkyloxy, beispielsweise Methoxy, Ethoxy, n- oder iso-Propoxy oder mit mindestens einer Sulfonatgruppe substituierten (C₂-C₁₈)-Alkyloxyester steht.
- n: für eine Zahl von 2 bis 10 000, vorzugsweise 3 bis 5 000 steht.

Insbesondere bevorzugt steht R^{C} und R^{D} unabhängig voneinander für Wasserstoff, aber nicht beide gleichzeitig, oder einen der oben angegebenen Reste, wobei der Rest mit einer Sulfonatgruppe substituiert ist.

Besonders bevorzugt sind kationische oder neutrale Polyalkylendioxythiophene der Formeln (Ba-1) und (Bb-1) 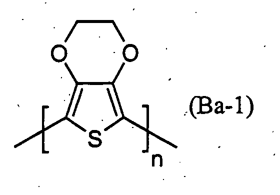 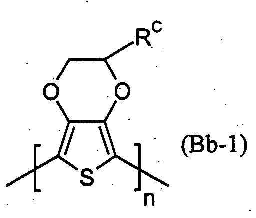 worin
- R^{C}: für mit mindestens einer Sulfonatgruppe substituiertes (C₁-C₁₈)-Alkyl, vorzugsweise (C₁-C₁₀)-, insbesondere (C₁-C₆)-Alkyl, mit mindestens einer Sulfonatgruppe substituiertes (C₂-C₁₂)-Alkenyl, vorzugsweise (C₂-C₈)-Alkenyl, mit mindestens einer Sulfonatgruppe substituiertes (C₃-C₇)-Cycloalkyl, vorzugsweise Cyclopentyl, Cyclohexyl, mit mindestens einer Sulfonatgruppe substituiertes (C₇-C₁₅)-Aralkyl, vorzugsweise Phenyl-(C₁-C₄)-alkyl, mit mindestens einer Sulfonatgruppe substituiertes (C₆-C₁₀)-Aryl, vorzugsweise Phenyl, Naphthyl, mit mindestens einer Sulfonatgruppe substituiertes (C₁-C₁₈)-Alkyloxy, vorzugsweise (C₁-C₁₀)-Alkyloxy, beispielsweise Methoxy, Ethoxy, n- oder iso-Propoxy oder mit mindestens einer Sulfonatgruppe substituierten (C₂-C₁₈)-Alkyloxyester und
- n: für eine ganze Zahl von 2 bis 10 000, vorzugsweise 3 bis 5 000 steht.

Insbesondere bevorzugt steht R^{C} für einen der oben angegebenen Reste, wobei der Rest mit einer Sulfonatgruppe substituiert ist.

In einer weiteren bevorzugten Ausführungsform der Erfindung steht n in den genannten Formeln für eine ganze Zahl von 4 bis 15.

Als Gegenionen zu den kationischen Polythiophenen dienen Polyanionen, welche beispielsweise die Anionen von polymeren Carbonsäuren, wie Polyacrylsäuren, Polymethacrylsäuren, Polymaleinsäuren und polymeren Sulfonsäuren, wie Polystyrolsulfonsäuren und Polyvinylsulfonsäuren. Diese Polycarbon- und -sulfonsäuren können auch Copolymere von Vinylcarbon- und Vinylsulfonsäuren mit anderen polymerisierbaren Monomeren, wie Acrylsäureestern und Styrol sein.

Besonders bevorzugt ist das Anion der Polystyrolsulfonsäure (PSS) als Gegenion.

Das Molekulargewicht der die Polyanionen liefernden Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben Weyl, Methoden der organischen Chemie, Bd. E 20 Makromolekulare Stoffe, Teil 2, (1987), S. 1141 u.f.).

Anstelle der für die Bildung der Dispersionen aus Polyalkylendioxythiophenen und Polyanionen erforderlichen freien Polysäuren, kann man auch Gemische aus Alkalisalzen der Polysäuren und entsprechenden Mengen an Monosäuren einsetzen.

Im Falle der Formel (Bb-1) tragen die Polyalkylendioxythiophene positive und negative Ladungen in der Struktureinheit, wobei sich die positiven Ladungen auf der Polythiophenhauptkette und die negativen Ladungen an den durch Sulfonatgruppen substituierten Resten R^{C} befinden. Die positiven Ladungen der Polythiophenhauptkette werden zum Teil oder vollständig durch die anionischen Gruppen an den Resten R^{C} abgesättigt.

Die Herstellung der Polyalkylendioxythiophene ist beispielsweise in EP-A 0 440 957 (US-A 5 300 575) beschrieben. Die Polyalkylendioxythiophene werden durch oxidative Polymerisation hergestellt. Dadurch erhalten sie positive Ladungen, die in den Formeln nicht dargestellt sind, da ihre Zahl und ihre Position nicht einwandfrei feststellbar sind.

Die Polythiophendispersion kann durch etablierte kostengünstige Verfahren wie Gießen, Drucken, Sprühen, Tauchen, Fluten oder Inkjet auf das transparente leitfähige Substrat aufgebracht werden. Auch hierbei ist kein kostenintensiver Vakuumprozess notwendig.

In einer weiteren bevorzugten Ausführungsform enthält die erfindungsgemäße elektrolumineszierende Schichtanordnung eine lochleitende Schicht, welche ein aromatisches Amin der Formel (C) enthält, 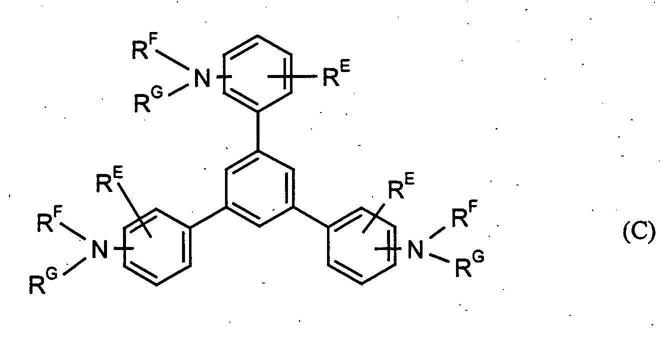 worin
- R^{E}: für Wasserstoff, gegebenenfalls substituiertes Alkyl oder Halogen steht und
- R^{F} und R^{G}: unabhängig voneinander für gegebenenfalls substituiertes (C₁-C₁₀)-Alkyl, Alkoxycarbonyl-substituiertes (C₁-C₁₀)-Alkyl, jeweils gegebenenfalls substituiertes Aryl, Aralkyl oder Cycloalkyl stehen.
- R^{F} und R^{G}: stehen unabhängig voneinander bevorzugt für (C₁-C₆)-Alkyl, insbesondere Methyl, Ethyl, n- oder iso-Propyl, n-, iso-, sec.- oder tert.-Butyl, (C₁-C₄)-Alkoxycarbonyl-(C₁-C₆)-alkyl, wie beispielsweise Methoxy-, Ethoxy-, Propoxy-, Butoxycarbonyl-(C₁-C₄)-alkyl, jeweils gegebenenfalls durch (C₁-C₄)-Alkyl und/oder (C₁-C₄)-Alkoxy substituiertes Phenyl-(C₁-C₄)-alkyl, Naphthyl-(C₁-C₄)-alkyl, Cyclopentyl, Cyclohexyl, Phenyl oder Naphthyl.

Besonders bevorzugt stehen R^{F} und R^{G} unabhängig voneinander für unsubstituiertes Phenyl oder Naphthyl oder jeweils einfach bis dreifach durch Methyl, Ethyl, n-, iso-Propyl, Methoxy, Ethoxy, n- und/oder iso-Propoxy substituiertes Phenyl oder Naphthyl.
- R^{E}: steht vorzugsweise für Wasserstoff, (C₁-C₆)-Alkyl, wie beispielsweise Methyl, Ethyl, n- oder iso-Propyl, n-, iso-, sec.- oder tert.-Butyl oder Chlor.

Derartige Verbindungen und deren Herstellung sind in US-A 4 923 774 für den Einsatz in der Elektrophotographie beschrieben. Die Tris-Nitrophenyl-Verbindung kann beispielsweise durch allgemein bekannte katalytische Hydrierung, beispielsweise in Gegenwart von Raney-Nickel in die Tris-aminophenyl-Verbindung überführt werden (Houben-Weyl 4/1C, 14-102, Ullmann (4) 13, 135-148). Die Aminoverbindung wird in allgemein bekannter Weise mit substituierten Halogenbenzolen umgesetzt.

Beispielhaft seien folgende Verbindungen der allgemeinen Formel (C) genannt:

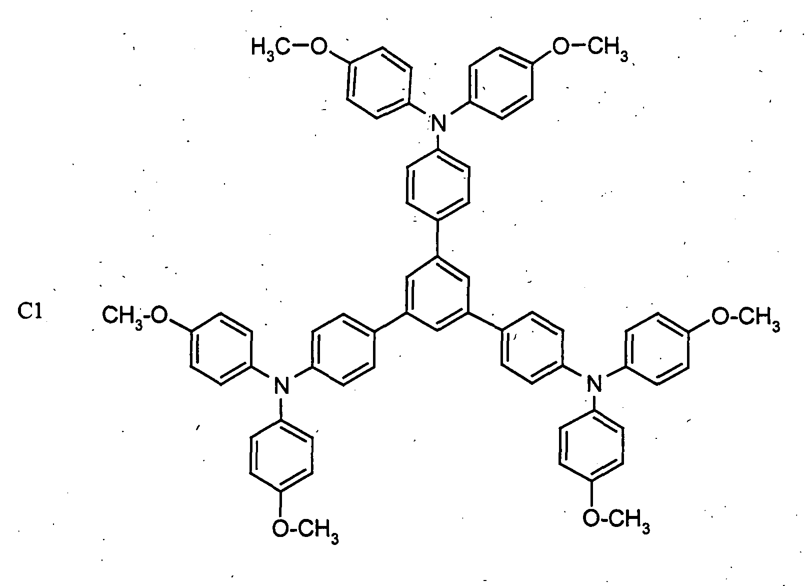

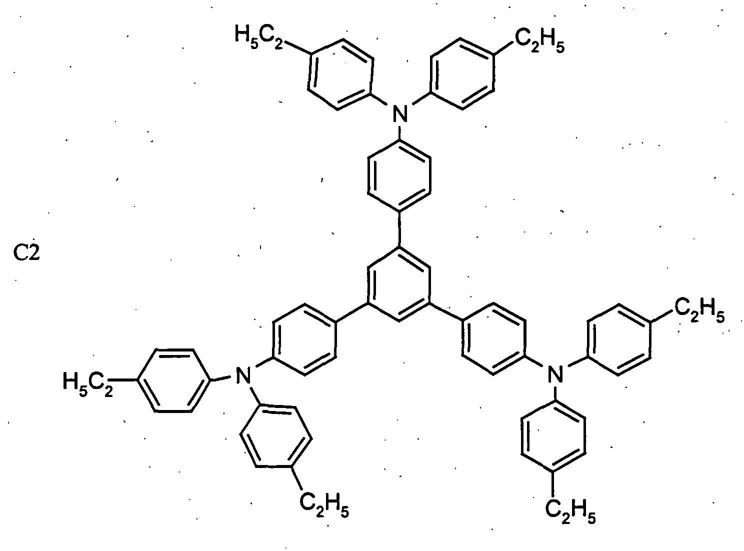

Neben der tertiären Aminoverbindung können gegebenenfalls weitere Lochleiter, z.B. in Form einer Mischung mit der tertiären Aminoverbindung, zum Aufbau des elektrolumineszierenden Elementes eingesetzt werden. Dabei kann es sich einerseits um eine oder mehrere Verbindungen der Formel (VI), wobei auch Gemische von Isomeren umfasst werden, andererseits auch um Mischungen von lochtransportierenden Verbindungen mit Verbindungen von tertiären Aminoverbindungen - mit der allgemeinen Formel (VI) - mit verschiedener Struktur handeln.

Eine Zusammenstellung möglicher lochleitender Materialien ist in EP-A 0 532 798 angegeben.

Im Falle von Mischungen der aromatischen Amine können die Verbindungen in einem beliebigen Verhältnis eingesetzt werden.

Die vorangehend beschriebenen Verbindungen mit lochleitenden bzw. lochtransportierenden Eigenschaften können ebenfalls, wie bereits an anderer Stelle dieser Anmeldung beschrieben, als niedermolekulare Matrix zur Einbettung der erfindungsgemäßen mehrkernigen Metallkomplexe in der lichtemittierenden Schicht dienen.

Vorzugsweise enthält die erfindungsgemäße Schichtanordnung zusätzlich eine Elektronentransportschicht. Eine Vielzahl von Verbindungen, die sich zum Einsatz in einer solchen Schicht eignen, ist bereits bekannt.

So wird gemäß WO 00/70 655 A2 beispielsweise Alq₃ eingesetzt. Bei dieser Verbindung handelt es sich um ein Pigment, das sich auf Grund seiner Unlöslichkeit in gängigen Lösemitteln ausschließlich in einem Aufdampfprozess aufbringen lässt.

Vorzugsweise wird daher zur Herstellung der Elektronentransportschicht ein Galliumkomplex aus der Gruppe Ga(qa)₂OR^{H}, Ga(qa)₂OCOR^{H}, Ga(qa)₂Cl, Ga(qa)₂F oder Ga(qa)₂-O-Ga(qa)₂ eingesetzt (beschrieben in Elschner et al., Adv. Mater. 2001, 13, 1811-1814 oder der noch unveröffentlichten deutschen Patentanmeldung DE-A 10 225 826).

In einer weiteren bevorzugten Ausführungsform enthält die elektronentransportierende Schicht der erfindungsgemäßen elektrolumineszierenden Schichtanordnung einen Galliumkomplex aus der Gruppe Ga(qa)₂-OR^{H}, Ga(qa)₂-OCOR^{H} oder Ga(qa)₂-O-Ga(qa)₂ enthält, wobei
- R^{H}: für substituiertes oder unsubstituiertes Alkyl, Alkenyl, Aryl, Arylalkyl oder Cycloalkyl und 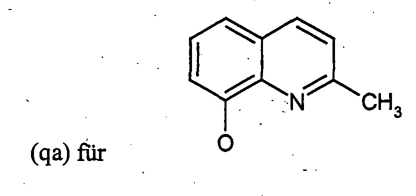 steht.

Diese Gallium-Verbindungen lassen sich im Gegensatz zu Alq₃ sowohl aus Lösung als auch mittels Aufdampfverfahren verarbeiten. Geeignete Lösungsmittel sind beispielsweise Methanol, Ethanol, n-Propanol oder iso-Propanol.

Vorzugsweise steht R^{H} für mit Halogen oder Cyano substituiertes oder unsubstituiertes, gegebenenfalls verzweigtes Alkyl oder Alkenyl, insbesondere für mit Halogen oder Cyano substituiertes oder unsubstituiertes, gegebenenfalls verzweigtes (C₁-C₈)-Alkyl oder -Alkenyl, besonders bevorzugt für mit Halogen oder Cyano substituiertes oder unsubstituiertes, gegebenenfalls verzweigtes (C₁-C₆)-Alkyl oder -Alkenyl. Als Halogen ist Fluor und Chlor bevorzugt.

Beispielsweise werden Gallium-Verbindungen der Formeln (D1) bis (D4) eingesetzt.

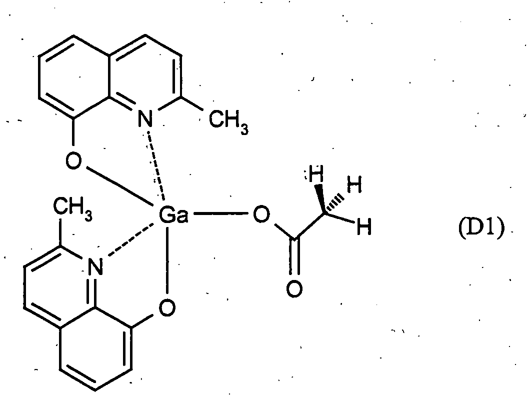

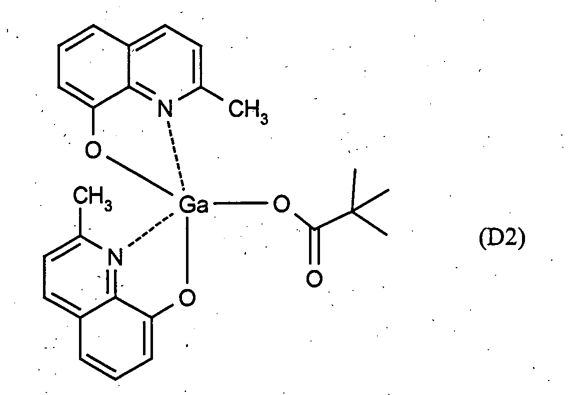

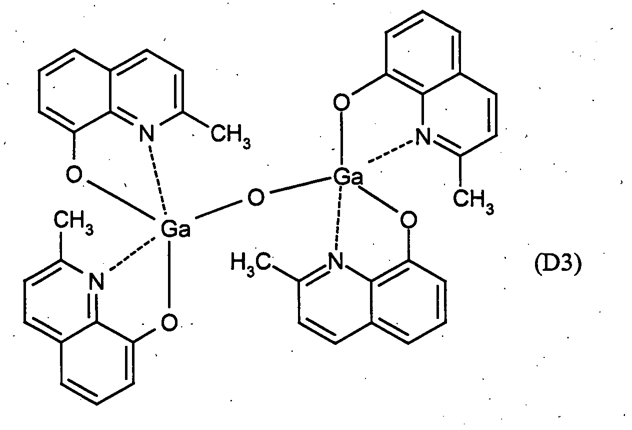

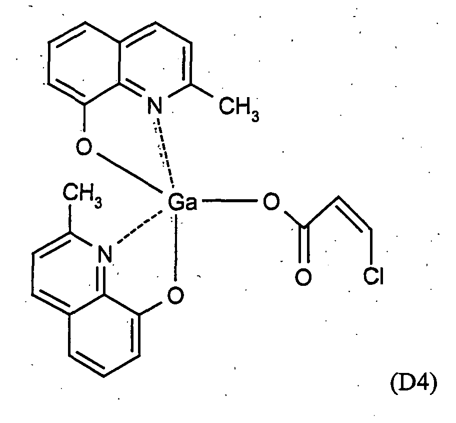

Als transparentes Substrat, das mit einer leitfähigen Schicht (Elektrode) versehen ist, sind Glas, Dünnstglas (flexibles Glas) oder Kunststoffe geeignet.

Besonders geeignete Kunststoffe sind: Polycarbonate, Polyester, Copolycarbonate, Polysulfon, Polyethersulfon, Polyimid, Polyethylen, Polypropylen oder cyclische Polyolefine bzw. cyclische Olefincopolymere (COC), hydrierte Styrolpolymere oder hydrierte Styrolcopolymere.

Bevorzugte Polymere sind Polycarbonate, Polyester, Polysulfon, Polyethersulfon, cyclische Olefincopolymere, hydrierte Styrolpolymere und hydrierte Styrolcopolymere. Aus der Gruppe der Polyester sind PET und PEN (Polyethylenterephthalat bzw. Polyethylennaphthenat) bevorzugt.

Geeignete Polymersubstrate sind beispielsweise Polyesterfolien, PES-Folien der Firma Sumitomo oder Polycarbonatfolien der Firma Bayer AG (Makrofol®).

Diese Substrate können durch eine zusätzliche Schicht kratzfest und/oder chemikalienresistent ausgerüstet sein, z.B. Marnot®-Folien (Bayer AG).

Aus der Gruppe der Polycarbonate sind besonders die Poly- oder Copolycarbonate geeignet, die eines der nachfolgenden Segmente enthalten:

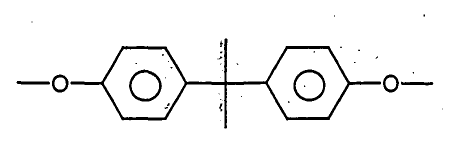

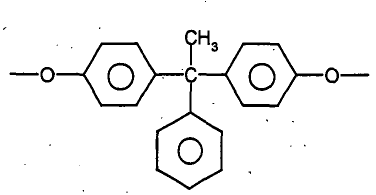

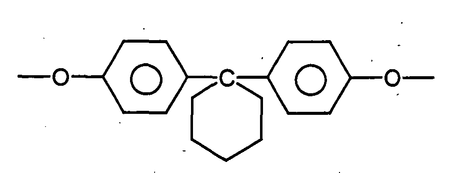

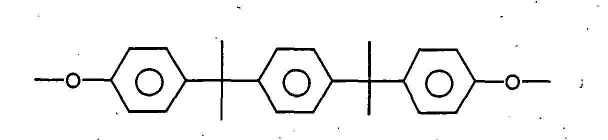

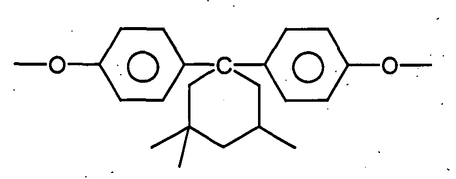

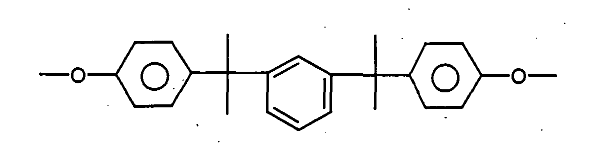

Weitere Bisphenole zum Aufbau von Polycarbonaten sind beispielsweise beschrieben in EP-A 359 953.

In einer weiteren bevorzugten Ausführungsform ist die erfindungsgemäße elektrolumineszierende Schichtanordnung gekapselt.

Weitere bevorzugte Ausführungsformen der erfindungsgemäßen elektrolumineszierenden Schichtanordnung sind alle beliebigen Kombinationen aus vorangehend beschriebenen bevorzugten Ausführungsformen.

Die erfindungsgemäße elektrolumineszierende Schichtanordnung eignet sich insbesondere als Bestandteil in lichtemittierenden Bauteilen wie beispielsweise organischen elektrolumineszierenden Anordnungen, Phosphoreszenzanzeigen, organische Leuchtdioden, Laseranwendungen, Beleuchtungselementen, großflächigen Strahlungsquellen etc.. Demnach sind lichtemittierende Bauteile, die eine erfindungsgemäße elektrolumineszierende Schichtanordnung enthalten, ebenfalls Gegenstand der Erfindung.

Die erfindungsgemäße Schichtanordnung kann beispielsweise wie folgt hergestellt werden: Ein organisches elektrisch leitfähiges Polythiophen gemäß der allgemeinen Formel (B) wird in Form einer Lösung oder Dispersion auf ein mit einer Indium-Zinn-Oxid-Schicht (ITO-Schicht) elektrisch leitfähig beschichtetes Substrat aufgebracht. Ein nachfolgender Temperprozess dient zur Entfernung der Lösungsmittelanteile. Die bevorzugt eingesetzten Amine der Formel (C) werden anschließend ebenfalls in Form eines Nassbeschichtungsschritts auf die Schicht des organischen leitfähigen Polymersystems aufgebracht. Auch hier erfolgt ein Temperschritt zur Entfernung des Lösungsmittels. Eine nachfolgende lichtemittierende Schicht, enthaltend die erfindungsgemäßen mehrkernigen Phosphoreszenz-Emitter wird ebenfalls durch einen Nassbeschichtungsschritt aus Lösung aufgebracht.

Anschließend wird gegebenenfalls eine löcherblockierende Schicht aufgedampft. Eine nunmehr folgende Elektronentransportschicht aus einer Galliumkomplexverbindung wird nun vorzugsweise wieder aus einer Lösung, beispielsweise in Methanol, auf die lichtemittierende Schicht bzw. die löcherblockierende Schicht aufgebracht.

Zur Herstellung einer elektrolumineszierenden Anordnung kann dann beispielsweise ein Metallsubstrat, gegebenenfalls wiederum durch Aufdampfen, aufgebracht werden, das als Kathode dient. Die ITO-Schicht fungiert dabei als Anode.

Der Vorteil des erfindungsgemäßen Schichtaufbaus besteht somit auch in der deutlichen Reduzierung der notwendigen Hochvakuumbeschichtungsschritte beim Aufbau aller organischen Funktionsschichten.

Ebenfalls Gegenstand der Erfindung ist daher ein Verfahren zur Herstellung der erfindüngsgemäßen elektrolumineszierenden Schichtanordnungen, dadurch gekennzeichnet, dass die die erfindungsgemäßen mehrkernigen Metallkomplexe enthaltende lichtemittierende Schicht aus Lösung aufgebracht wird.

Für den Fall, dass die erfindungsgemäßen mehrkernigen Metallkomplexe in der lichtemittierenden Schicht der erfindungsgemäßen elektrolumineszierenden Schichtanordnungen in eine niedermolekulare oder polymere Matrix eingebettet sein sollen, ist dies ein Verfahren, dadurch gekennzeichnet, dass die erfindungsgemäßen mehrkernigen Metallkomplexe zusammen mit der Matrix aus Lösung aufgebracht werden.

Die erfindungsgemäßen mehrkernigen Metallkomplexe sind in der Lösung zu einem Anteil von 0,01 bis 5 Gewichtsprozent, besonders bevorzugt 0,1 bis 2 Gewichtsprozent enthalten. Bevorzugte Lösungsmittel sind Toluol, Chloroform, Chlorbenzol, Trichlorbenzol, Xylole etc.

### Beispiele

Alle verwendeten Edukte sind entweder käuflich erhältlich oder nach bekannten und gängigen Verfahren herstellbar.

Die für diverse Liganden im Folgenden verwendeten Abkürzungen haben die folgende Bedeutung:
- ppy:: Phenyl-2-pyridin
- bthpy:: 2-Benzo[b)thiophen-2-yl-pyridin
- F-ppy:: 4-Fluorphenyl-2-pyridin

### Beispiel 1:

### Beispielhafte Synthese des Ir-Komplezes L₂Ir(µ-Cl)₂IrL₂ (mit L = 2-Phenylpyridin)

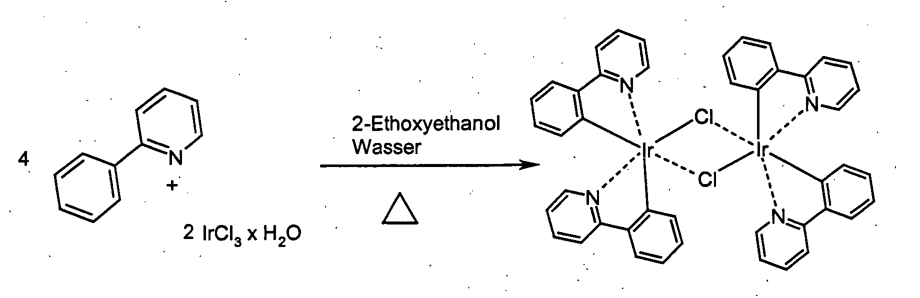

Ein Gemisch aus 1,0 g (2,84 mmol) Iridium(lI1)7-tris-chlorid-Hydrät und 0,88 g (5,67 mmol) 2-Phenylpyridin in 100 ml frisch destilliertem 2-Ethoxyethanol sowie 33 ml destilliertem Wasser wird mehrmals an der Ölpumpe entgast und jeweils mit Stickstoff belüftet. Unter Stickstoff wird der Reaktionsansatz 13 Stunden am Rückfluss gekocht. Danach saugt man den ausgefallenen Feststoff ab und wäscht mit Ethanol nach. Nach dem Trocknen im Vakuumtrockenschrank bei 50°C erhält man einen gelben Feststoff.
Ausbeute: 0,97 g (63,8 % der theoretischen Ausbeute)
Charakterisierung: ¹H-NMR (400-MHz, d6-DMSO, 25°C, TMS)

Alle weiteren im Folgenden verwendeten Iridium-Komplexe L₂Ir(µ-Cl)₂IrL₂ können nach der gleichen Synthesevorschrift hergestellt werden.

### Beispiel 2-a:

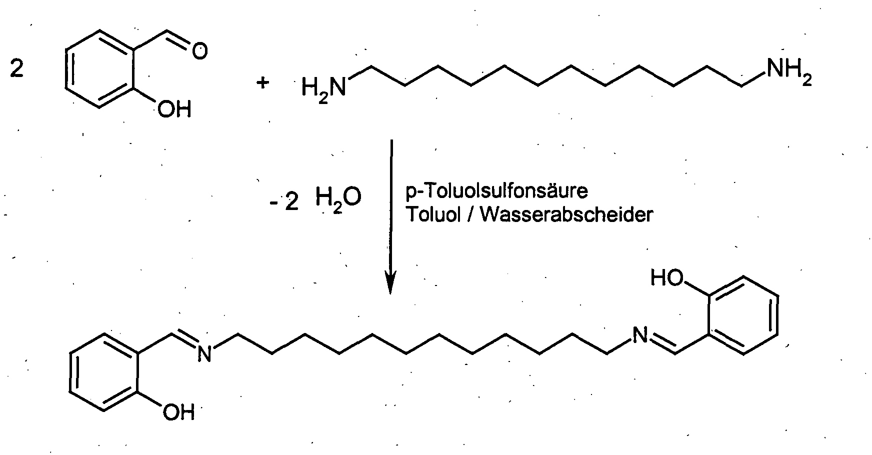

61,06 g (0,5 mol) 2-Hydroxybenzaldehyd und 50,09 g (0,25 mol) 1,12-Diaminododecan werden in 500 ml getrocknetem Toluol (über Molsieb 4 Å) mit 0,5 g p-Toluolsulfonsäure als Katalysator versetzt und unter Wasserabspaltung zur Schiffschen Base umgesetzt. Nach dem neutral und salzfrei gewaschen wurde, wird das erhaltene Rohprodukt insgesamt noch zweimal in Toluol umkristallisiert. Nach dem Trocken bei 55°C (Trockenpistole, Hochvakuum) erhält man einen neongelben, pulverförmigen Feststoff.
Ausbeute: 9,04 g (8,8% der theoretischen Ausbeute)
Charakterisierung: ¹H-NMR (400 MHz, CDCl₃, 25°C, TMS) δ = 1.31 (16H, CH₂), 1.64 (4H, CH₂-CH₂-N=), 3.55 (4H, CH₂-N=), 7.28-6.85 (8H, arom.), 8.30 (2H, -CH=N), 13.7 (2H, OH).

### Beispiel 2-b:

Die analoge Umsetzung von 2-Hydroxybenzaldehyd mit Diaminodecan erfolgt wie in Beispiel 2-a beschrieben.

### Beispiel 2-c:

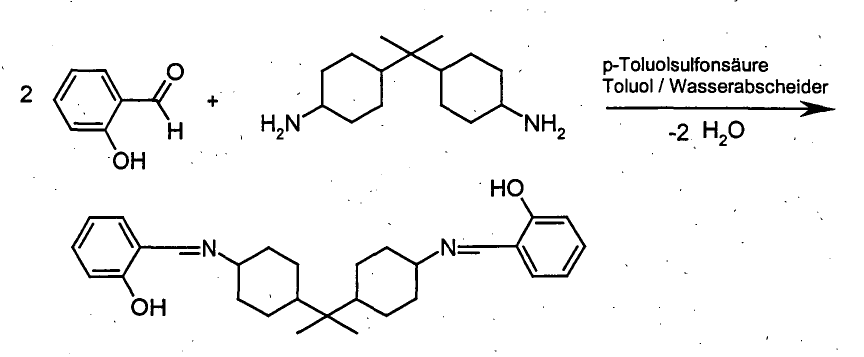

9,77 g (80 mmol) 2-Hydroxybenzaldehyd wurden auf analoge Weise mit 9,54 g (40 mmol) der Cyclohexylaminverbindung umgesetzt.

Zur Reinigung wird das Rohprodukt in Methylenchlorid gelöst und in Petrolether 40/60 gefällt: Das Produkt wir abgesaugt und im Vakuumtrockenschrank getrocknet. Man erhält ein gelbes Pulver.

Fp 179°C
Charakterisierung: ¹H-NMR(400 MHz, CDCl₃) : δ =0.78 (6 H, CH₃,), 6.83 bis 7.30 (16 H, Protonen am Aromaten), 8.16 (2 H, =CH), 13.7 (2 H OH).
Ausbeute: 4,3 g (=25% der Theorie)

### Beispiel 2-d:

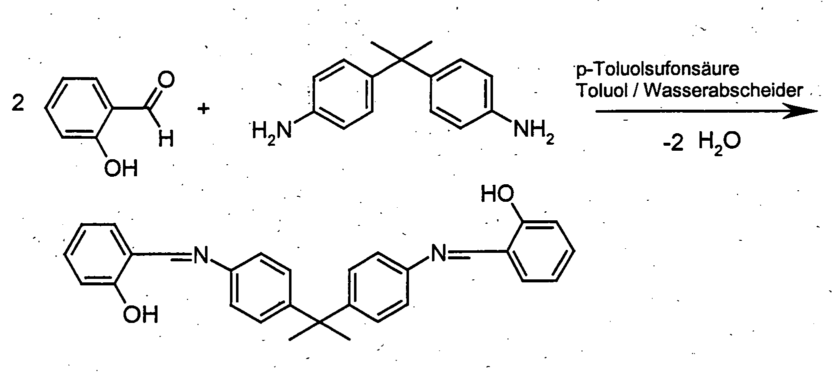

9,77 g (80 mmol) 2-Hydroxybenzaldehyd wurden auf analoge Weise mit 9,05 g (40 mmol) der Anillinverbindung umgesetzt.

Zur Reinigung wird das Rohprodukt in Methylenchlorid gelöst und in Petrolether 40/60 gefällt. Das Produkt wir abgesaugt und im Vakuumtrockenschrank getrocknet. Man erhält ein gelbes Pulver.

Fp: 174°C
Charakterisierung: ¹H-NMR( 400 MHz, CDCl₃) : δ = 1.69 (6H, CH₃,), 6.92 bis 7.48 (16H, Protonen am Aromaten), 8.61 (2H, =CH), 13.3 (2H OH).
Ausbeute: 14,6 g (=84% der Theorie)

### Beispiel 2-e:

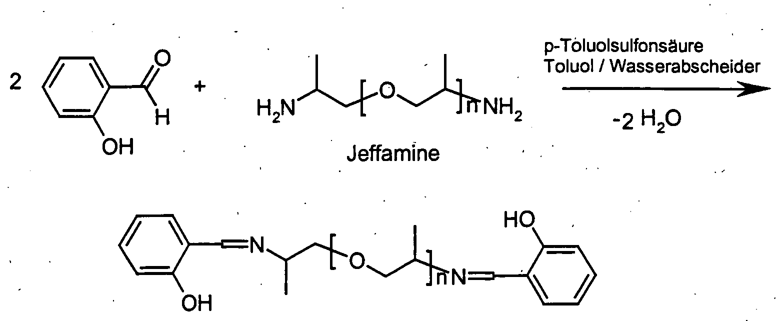

32,24 g (0,264 mol) 2-Hydroxybenzaldehyd und 239,59 g (0,12 mol) Jeffamine® D-2000 (n = 33.1, Huntsman) werden im Mol-Verhältnis 2,2:1 in 250 ml getrocknetem Toluol (über 4 Å Molsieb) umgesetzt. Als Katalysator wird der Reaktion 0,5 g p-Toluolsulfonsäure zugeführt.

Beim Erhitzen unter Rückfluss wird das entstehende Reaktionswasser am Wasserabscheider entfernt. Das erhaltene Rohprodukt wird mit destilliertem Wasser neutral und elektrolytfrei gewaschen und mittels einer Säulenchromatographie (Elutionsmittel Toluol) gereinigt.

Nach der Aufarbeitung erhält man eine orange, mittelviskose, klare Flüssigkeit.

### Beispiel 2-f:

Die analoge Umsetzung von 0,12 mol Jeffamine® D-230 (n = 2.6, Huntsman) mit 2-Hydroxybenzaldehyd erfolgt wie in Beispiel 2-e beschrieben.

### Beispiel 2-g:

Die analoge Umsetzung von 0,12 mol Jeffamine® D-4.00 (n =5.6, Huntsman) mit 2-Hydroxybenzaldehyd erfolgt wie in Beispiel 2-e beschrieben.

### Beispiel 2-h:

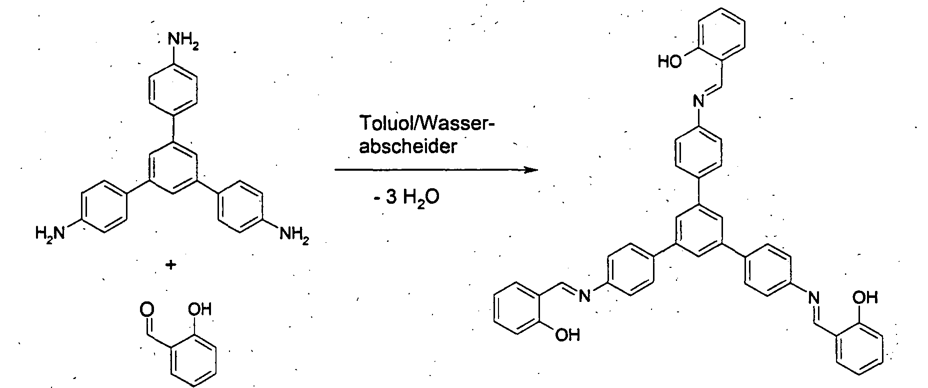

4,0 g (11,4 mmol) 1,3,5-Tris(4-aminophenyl-)benzol wird mit 1,4 g (11,4 mmol) Salicylaldehyd in 100 mL Toluol am Wasserabscheider 12 h gekocht. Die klare rotbraune Lösung wird auf 10 mL eingeengt und das Rohprodukt bei 4°C auskristallisiert. Zur Aufreinigung wird aus Ethanol (100 mL) / Toluol (25 mL) umkristallisiert, anschließend an Kieselgel chromatographiert (CH₂Cl₂ / Methanol 99 : 1) und das Produkt abschließend nochmals aus Ethanol / Toluol umkristallisiert. Nach dem Trocknen erhält man einen gelben Feststoff, der unter der UV-Lampe (366 nm) gelb leuchtet.
Ausbeute: 1,2 g (16%d. Th.)
Fp. 191°C
¹H NMR (400 MHz, CDCl₃, TMS) δ = 8.73 (s; 3H; N=CH-); 7.84 (s; 3H; H2, H4, H6); 7.79 (d; 6H), 7.46 - 7.38 (m; 12 H), 7.06 (d; 3H; Hₛₐₗ), 6.98 (t; 3H; Hₛₐₗ).

### Beispiel 2-i:

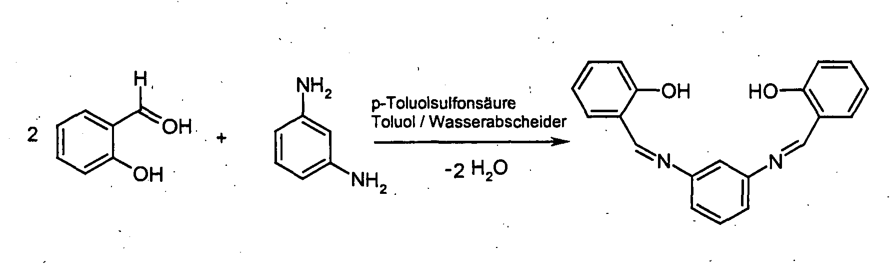

61,06 g (0,50 mol) 2-Hydroxybenzaldehyd und 27,04 g (0,25 mol) m- Phenylendiamin werden im Mol-Verhältnis 2:1 in 500 ml getrocknetem Toluol (über 4 Å Molsieb) umgesetzt. Als Katalysator wird der Reaktion 0,5 g p-Toluolsulfonsäure zugeführt. Beim Erhitzen unter Rückfluss wird das entstehende Reaktionswasser am Wasserabscheider entfernt. Das erhaltene Rohprodukt wird mit destilliertem Wasser neutral und elektrolytfrei gewaschen und im Vakuumtrockenschrank bei 90°C getrocknet. Nach dem Trocknen erhält man gelb-orangefarbene Kristalle.
Ausbeute: 68,9 g (87,1 % der theoretischen Ausbeute).
Reinigung: 10 g Rohprodukt werden in 50 ml Toluol umkristallisiert und bei 70°C im Vakuumtrockenschrank getrocknet. Nach dem Trocknen erhält man einen leuchtend gelb-orangefarbenen Feststoff.
Ausbeute: 5,0 g (50 % der theoretischen Ausbeute)
Fp.: 108°C
Charakterisierung: ¹H-NMR (400 MHz, CDCl₃): 13.09 (2 H, OH); 8.64 (2 H, N=CH-); 7.46 bis 6.93 (12 H, arom. Protonen).

### Beispiel 2-j:

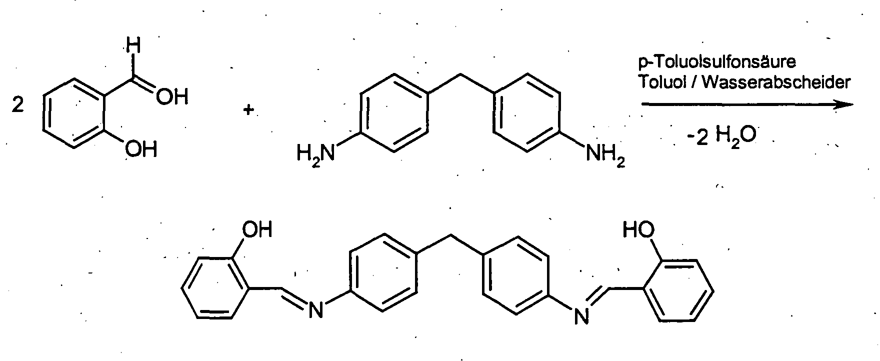

61,06 g (0,50 mol) 2-Hydroxybenzaldehyd und 49,57 g ( 0,25 mol) 4,4- Diaminodiphenylmethan werden im Mol-Verhältnis 2:1 in 700 ml getrocknetem Toluol (über 4 Å Molsieb) umgesetzt. Als Katalysator wird der Reaktion 0,5 g p-Toluolsulfonsäure zugeführt. Beim Erhitzen unter Rückfluss wird das entstehende Reaktionswasser am Wasserabscheider entfernt. Das erhaltene Rohprodukt wird mit destilliertem Wasser neutral und elektrolytfrei gewaschen und im Vakuumtrockenschrank bei 90°C getrocknet. Nach dem Trocknen erhält man einen leuchtend gelben Feststoff.
Ausbeute: 93,8 g (92,3 % der theoretischen Ausbeute).
Reinigung:10 g Rohprodukt werden in 200 ml Chlorbenzol umkristallisiert und bei 70°C im Vakuumtrockenschrank getrocknet. Nach dem Trocknen erhält man einen leuchtend gelben Feststoff.
Ausbeute: 9,2 g (92 % der theoretischen Ausbeute)
Fp.: 216°C

Charakterisierung: ¹H-NMR (400 MHz, d6-DMSO):13.16 (2 H, OH); 8.94 (2 H, N=CH-); 7.64 bis 6.95 (16 H, arom. Protonen); 4.03 (2 H, Aromat-CH₂-Aromat).

### Beispiel 2-k:

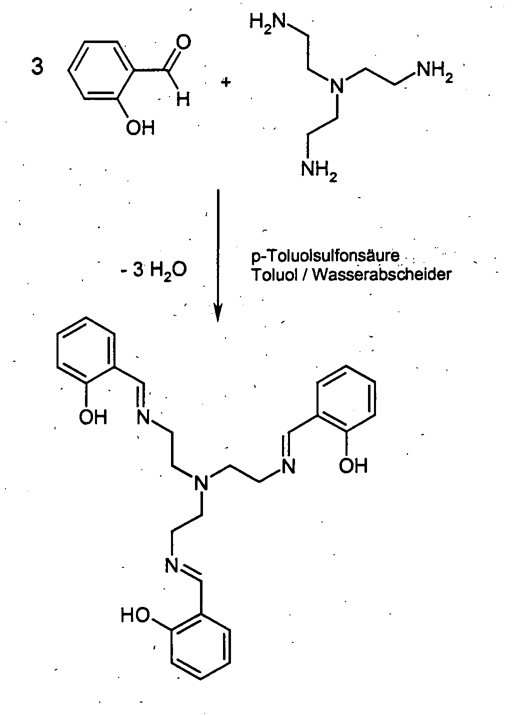

Analoge Umsetzung zu Beispiel 2-j. Umkristallisation des Rohproduktes aus Cyclohexanon/Petrolether 40-60 im Verhältnis 1:10.
¹H-NMR (CDCl₃, 400 MHz): 13.78 (3H, OH), 7.80 (3H, CH=), 7.29 - 6.07 (12H, arom.), 3.57 und 2.82 (je 6H, CH2-N= bzw. N-CH2).
Fp: 93°C

### Beispiel 3-a:

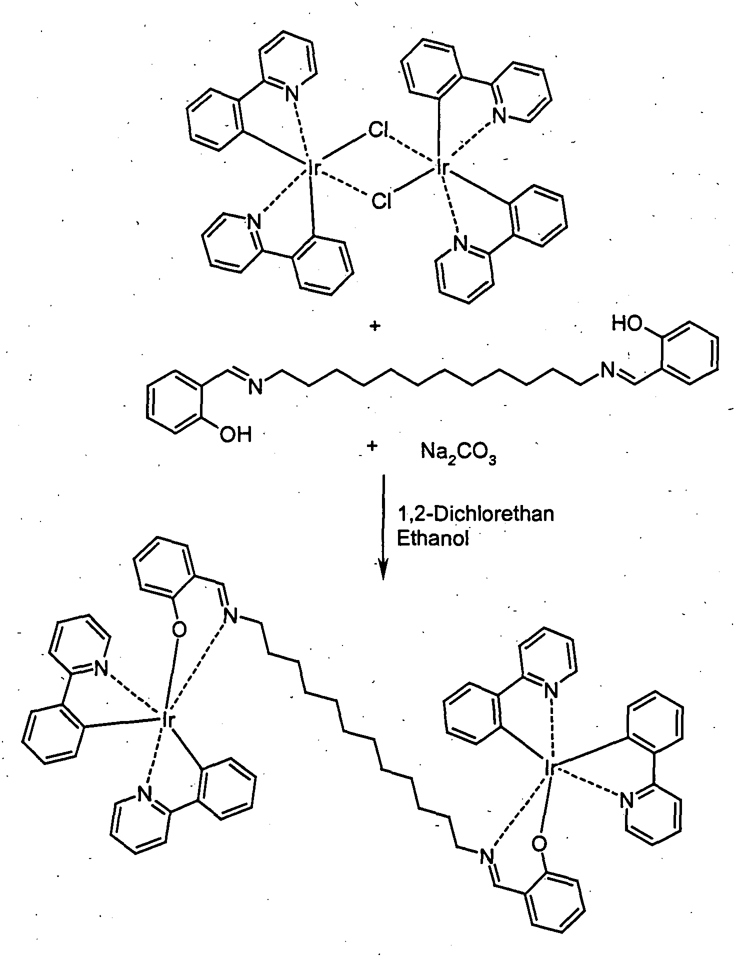

2,0 g (1,864 mmol) der Iridiumkomplexverbindung aus Beispiel 1 werden zusammen mit 0,762 g (1,864 mmol) der Schiff schen Base aus Beispiel 2-a und 0,212 g (2 mmol) Natriumcarbonat in einer Mischung aus 280 ml 1,2-Dichlorethan und 56 ml Ethanol unter Stickstoff 3 Stunden und 20 Minuten am Rückfluss gekocht. Der entstehende Niederschlag wird abgetrennt und mit Wasser neutral gewaschen. Das Rohprodukt wird mittels Flash-Chromatographie gereinigt. Nach dem Trocknen erhält man einen orangefarbenen Feststoff, der unter der UV-Lampe orange-rot emittiert.
Ausbeute: 0,2 g (7,6 % der theoretischen Ausbeute)
Charakterisierung: ¹H-NMR (400 MHz, CDCl₃, 25°C, TMS)
MALDI-TOF: C₇₀H₆₆N₆O₂Ir₂: ber.: 1407.8; gef.: 1407.

### Beispiel 3-b:

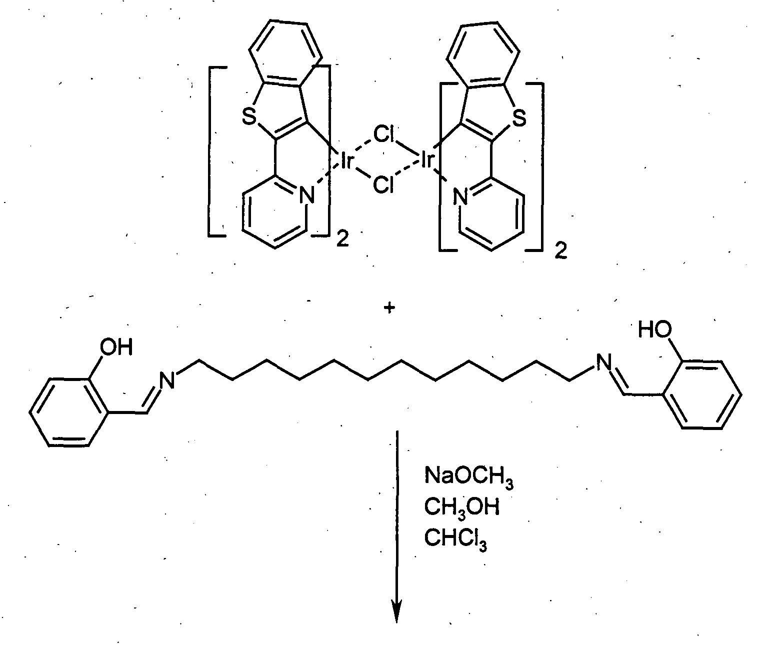

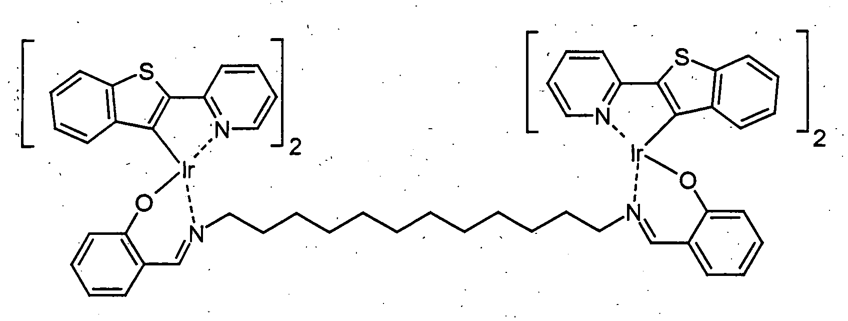

Unter Stickstoff Gegenstrom werden 18 mg (0,333 mmol) Natriummethanolat in 2 mL Methanol in einem sorgfältig ausgeheizten Kolben vorgelegt. Unter Rühren wird 67 mg (0,164 mmol) Schiff'sche aus Beispiel 2-a Base in 5 mL Chloroform und anschließend 200 mg (0,155 mmol) Iridiumkomplex ((bthpy)₂Ir(µ-Cl)₂Ir(bthpy)₂) in 20 mL Chloroform zugegeben. Die Lösung wird viermal durch Anlegen von Vakuum und nachfolgendem Belüften mit Stickstoff entgast und anschließend 14 Stunden unter Rückfluß erhitzt. Nach dem Abkühlen wird filtriert, der Rückstand mit 25 mL Chloroform aufgekocht, filtriert, und die Filtrate vereinigt. Das Lösungsmittel wird am Rotavapor abgezogen und der Rückstand in Toluol aufgenommen und mit n-Hexan ausgefällt. Das Produkt wird weiter gereinigt durch Chromatographie an Kieselgel (CH₂Cl₂). Man erhält einen orange-roten Feststoff, der unter der UV Lampe rot leuchtet. Lösungen (z.B. in Chloroform) leuchten unter der UV Lampe ebenfalls intensiv rot.
Ausbeute: 94,5 mg (35 % d. Th.)
Schmelzpunkt: 232°C (Zersetzung)
Charakterisierung: ¹H-NMR (400 MHz, CDCl₃, TMS).
MALDI-TOF (matrix): C₇₈H₆₆N₆O₂S₄Ir₂:M⁺ber. 1632,1; gef. 1631,9

### Beispiel 3-c:

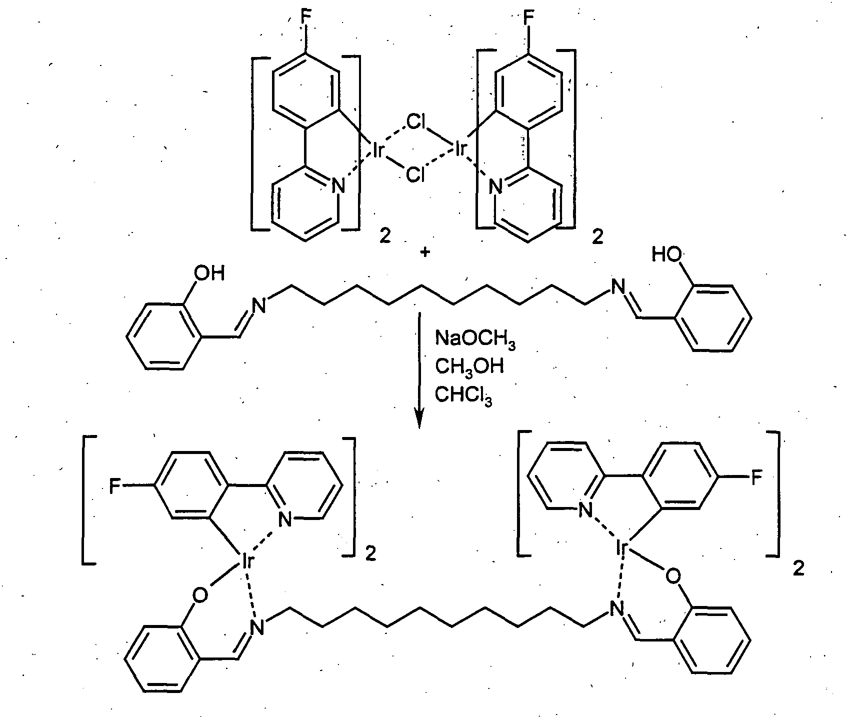

Unter Stickstoff-Gegenstrom werden 19 mg (0,35 mmol) Natriummethanolat in 2 mL Methanol in einem sorgfältig ausgeheizten Kolben vorgelegt. Unter Rühren wird 57 mg (0,15 mmol) Schiff'sche Base aus Beispiel 2-b und 200 mg (0,176 mmol) Iridiumkomplex ((F-ppy)₂Ir(µ-Cl)₂Ir(F-ppy)₂) in 25 mL Chloroform zugegeben. Die Lösung wird 3x durch Anlegen von Vakuum und nachfolgendem Belüften mit Stickstoff entgast und anschließend 22 h unter Rückfluß erhitzt. Nach dem Abkühlen wird filtriert und das Lösungsmittel am Rotavapor abgezogen. Das Produkt wird durch Chromatographie an Kieselgel (CH₂Cl₂ / Methanol 98,5 : 1,5) gereinigt. Man erhält einen gelben Feststoff, der unter der UV Lampe gelb leuchtet.
Ausbeute: 175 mg (69 % d. Th.)
Schmelzpunkt: 221°C (Zersetzung)
Charakterisierung: ¹H-NMR (400 MHz, CDCl₃, TMS).

### Beispiel 3-d:

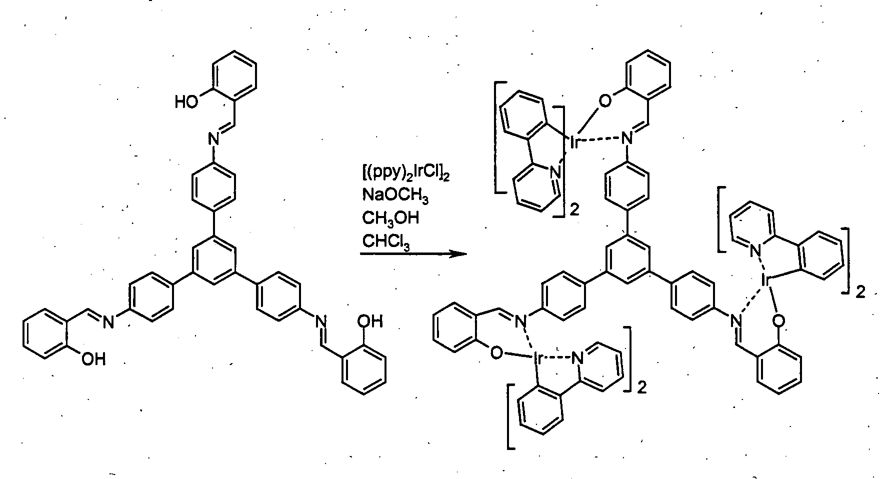

Unter Stickstoff-Atmosphäre werden 13,5 mg (0,25 mmol) Natriummethanolat in 1 mL Methanol in einem sorgfältig ausgeheizten Kolben vorgelegt. Unter Rühren wird 40 mg (0,06 mmol) Schiff'sche Base aus Beispiel 2-h und 100 mg (0,094 mmol) Iridiumkomplex ((ppy)₂Ir(µ-Cl)₂Ir(ppy)₂) in 25 mL Chloroform zugegeben und anschließend 14 h unter Rückfluß erhitzt. Nach dem Abkühlen wird filtriert und aufkonzentriert und an Kieselgel (CH₂Cl₂ : CH₃OH 97 : 3) chromatographiert. Die Produktfraktionen werden aufkonzentriert, bis zur beginnenden Fällung mit Hexan versetzt und über Nacht im Kühlschrank aufbewahrt. Nach Absaugen und Trocknen erhält man einen gelb-orangen Feststoff, der unter UV Lampe (366 nm) orange leuchtet.
Ausbeute: 91,5 mg (71 % d. Th.)
Schmelzpunkt: 344°C (Zersetzung)
Charakterisierung: ¹H-NMR (400 MHz, CDCl₃, TMS)
MALDI-TOF (matrix): C₁₁₁H₇₈N₉O₃Ir₃:M⁺ ber. 2162,5; gef. 2162,4

### Beispiel 3-e:

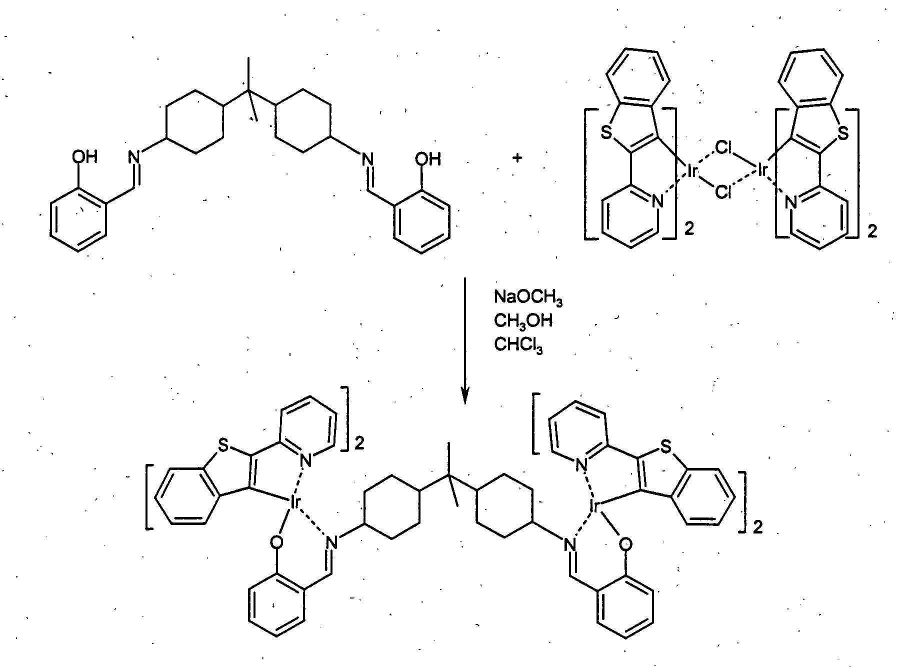

Durchführung analog Beispiel 3-c mit 40 mg (0.09 mmol) Schiff'scher Base aus Beispiel 2-c, 127 mg (0.099 mmol) Iridiumkomplex ((bthpy)₂Ir(µ-Cl)₂Ir(bthpy)₂), 10,8 mg (0.2 mmol) Natriummethanolat, 1 mL Methanol und 35 mL Chloroform. Reaktionszeit: 13,5 h, Chromatographie an Kieselgel mit CH₂Cl₂ : CH₃OH 98,5 : 1,5. Man erhält einen orangen Feststoff, der unter der UV Lampe (366 nm) rot leuchtet.
Ausbeute: 49,5 mg (33 %d.Th.)
Schmelzpunkt: 302°C (Zersetzung)
Charakterisierung: ¹H-NMR (400 MHz, CDCl₃, TMS)
MALDI-TOF (matrix): C₈₁H₆₈N₆O₂S₄Ir₂: M+ ber.: 1670,1; gef.: 1670,2

## Patentansprüche

1. Mehrkernige Metallkomplexe der allgemeinen Formel (I),
(LₘMe-H_{L})ₙX_{L} (I)
**dadurch gekennzeichnet, dass**
Me für ein Übergangsmetall steht,
L für einen bidentalen chelatbildenden Liganden steht,
H_{L} für einen bidentalen chelatbildenden Liganden steht, der das Übergangsmetall Me chelatartig komplexiert und zusätzlich an einen Linker X_{L} gebunden ist,
X_{L} für einen n-funktionellen Linker steht und an n Hilfsliganden H_{L} kovalent gebunden ist,
n für eine ganze Zahl von 2 bis 6 und
m für eine ganze Zahl von 1 bis 3 steht.

2. Mehrkernige Metallkomplexe gemäß Anspruch 1, **dadurch gekennzeichnet, dass**
L für einen bidentalen chelatbildenden Liganden ausgewählt aus den allgemeinen Formeln (II) bis (XIX) steht, 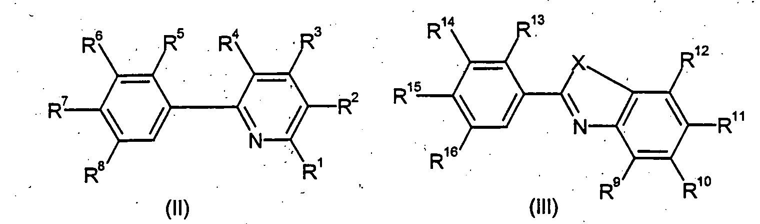 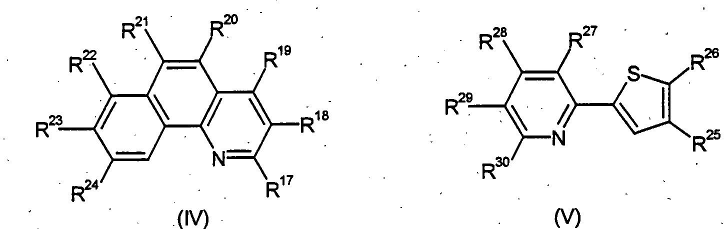 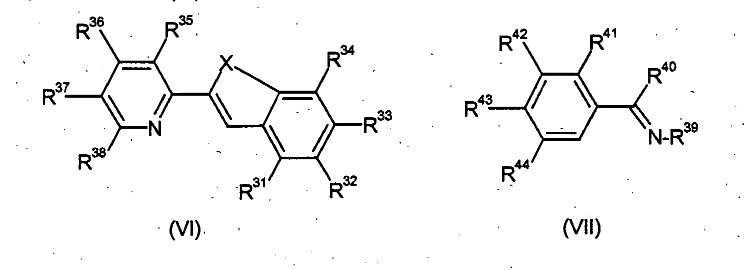 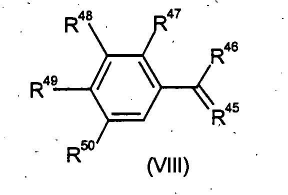 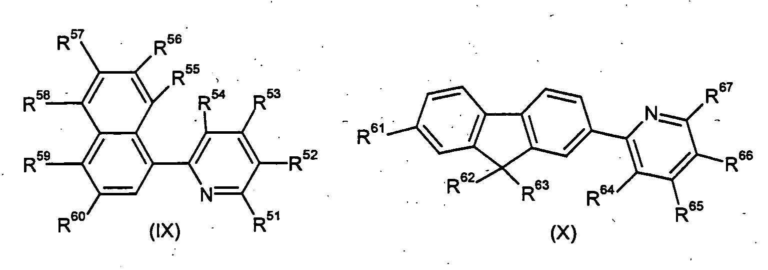 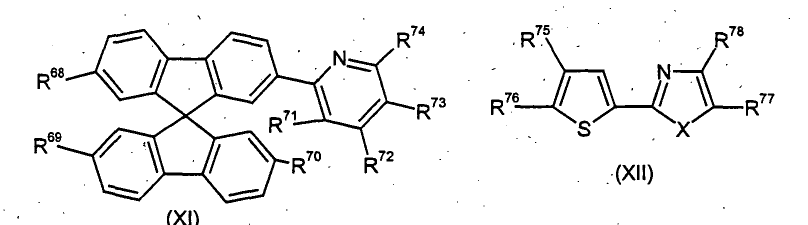 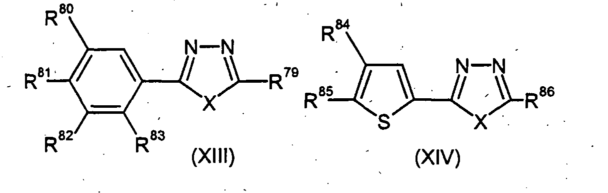 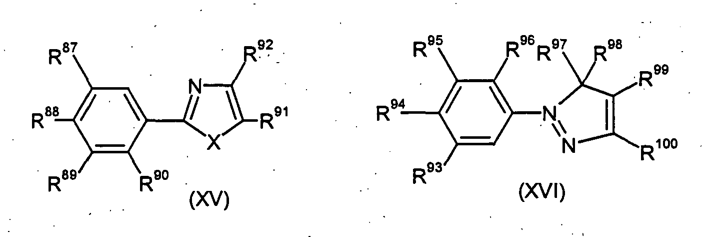 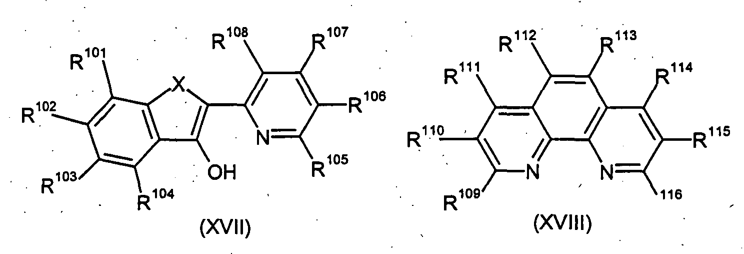 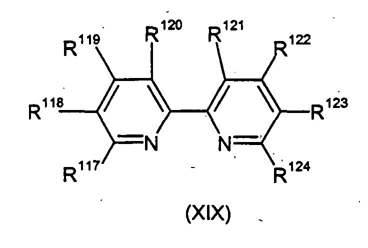 wobei
X für Sauerstoff, Schwefel oder N-Alkyl oder N-H steht,
R¹-R¹²⁴ gleich oder verschieden sind und unabhängig voneinander für H, F, CF₃, eine lineare oder verzweigte C₁-C₂₂-Alkylgruppe, eine lineare oder verzweigte C₁-C₂₂-Alkoxygruppe, eine gegebenenfalls C₁-C₃₀-alkylsubstituierte C₅-C₂₀-Aryleinheit und/oder eine gegebenenfalls C₁-C₃₀-alkylsubstituierte Heteroaryleinheit mit 5 bis 9 Ring-C-Atomen und 1 bis 3 Ringheteroatomen aus der Gruppe Stickstoff, Sauerstoff und Schwefel stehen.
H_{L} für einen bidentalen chelatbildenen Liganden ausgewählt aus den allgemeinen Formel (XX) bis (XXX) steht, das Übergangsmetall Me chelatartig komplexiert und über die mit * gekennzeichnete Verknüpfungsstelle an den Linker X_{L} gebunden ist, 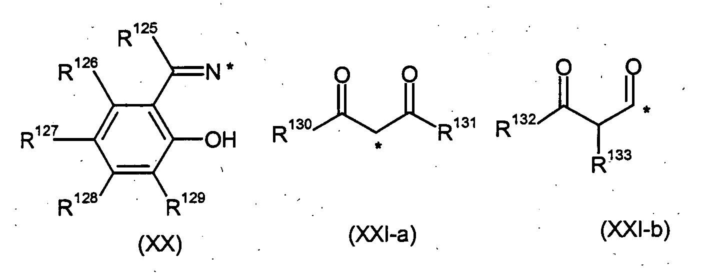 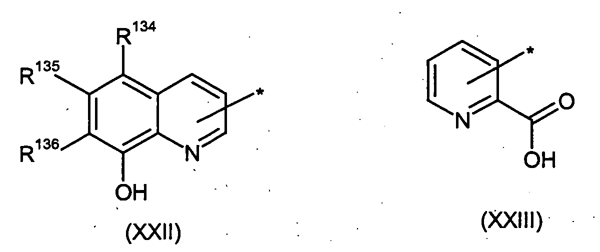 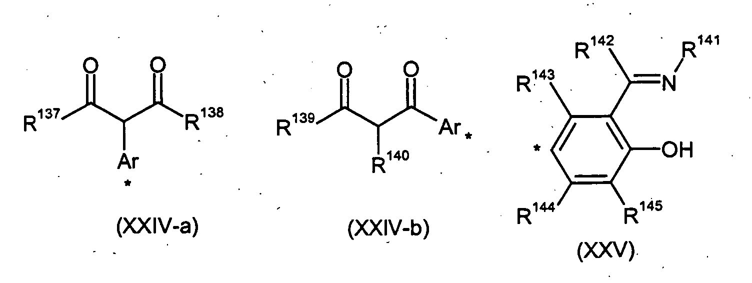 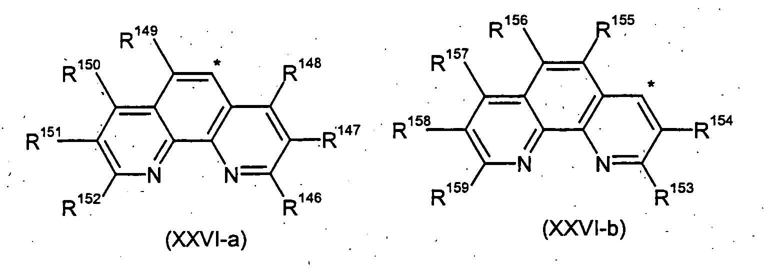 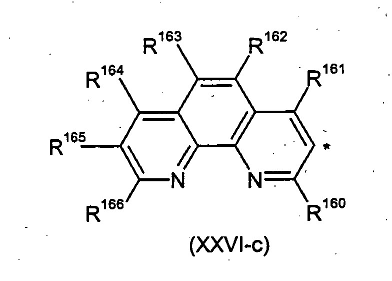 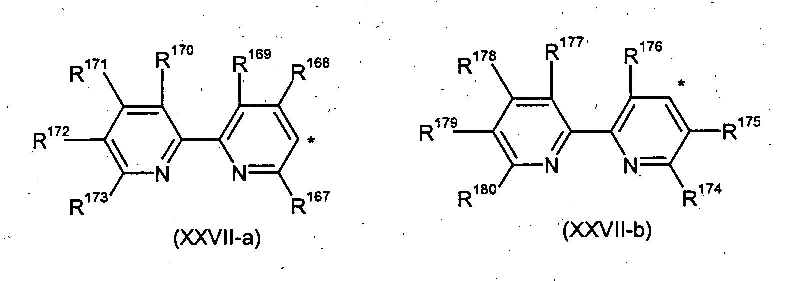 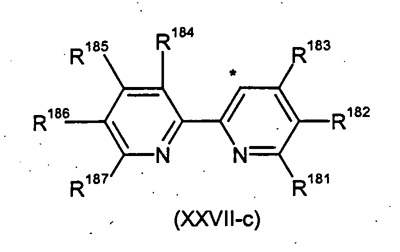 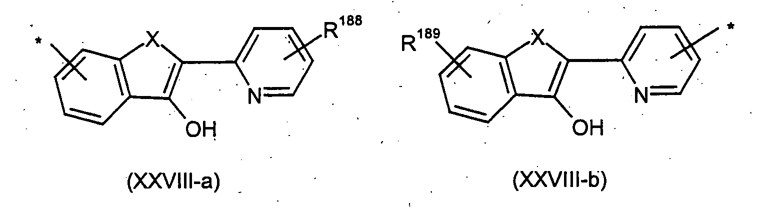 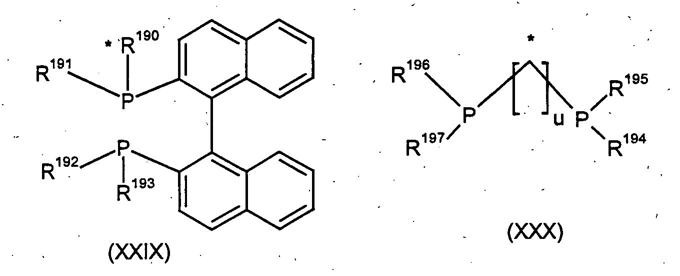
und
X für Sauerstoff, Schwefel oder N-Alkyl oder N-H steht,
u für eine ganze Zahl von 1 bis 6 steht,
Ar für gegebenenfalls durch eine lineare oder verzweigte C₁-C₃₀-Alkyl- oder C₁-C₃₀-Alkoxygruppe, F, Cyano oder CF₃- substituiertes Phenyl, Thienyl, Fluroenyl, Pyrrol, Carbazol oder 1,4-Phenylen-vinylen steht,
R¹²⁵-R¹⁹⁷ gleich oder verschieden sind und unabhängig voneinander für H, F, CF₃, eine lineare oder verzweigte C₁-C₂₂-Alkylgruppe, eine lineare oder verzweigte C₁-C₂₂-Alkoxygruppe, eine gegebenenfalls C₁-C₃₀-alkylsubstituierte C₅-C₂₀-Aryleinheit und/oder eine gegebenenfalls C₁-C₃₀-alkylsubstituierte Heteroaryleinheit mit 5 bis 9 Ring-C-Atomen und 1 bis 3 Ringheteroatomen aus der Gruppe Stickstoff, Sauerstoff und Schwefel stehen und
Me, X_{L} und n die in Anspruch 1 genannte Bedeutung haben.

3. Mehrkernige Metallkomplexe gemäß wenigstens einem der Ansprüche 1 oder 2, **dadurch gekennzeichnet, dass**
X_{L} ein n-funktioneller Linker ausgewählt aus den folgenden allgemeinen Formeln (XXXI) bis (XXXXVI) ist, 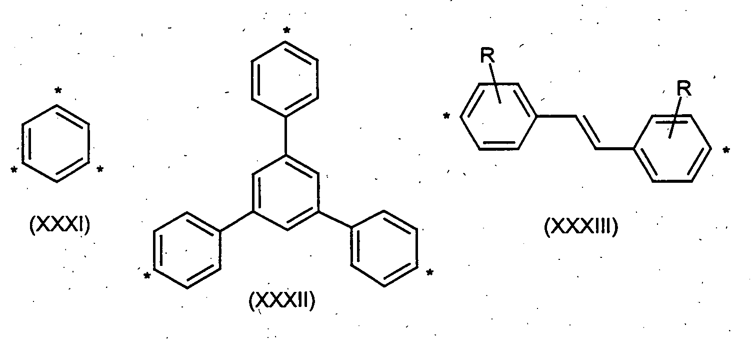 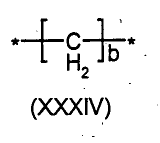 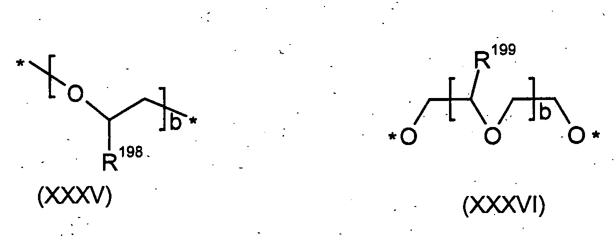 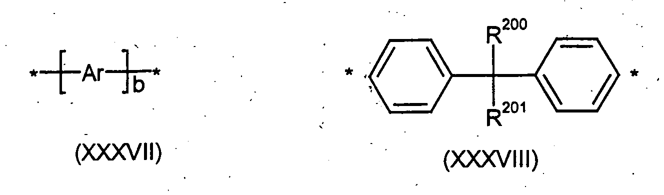 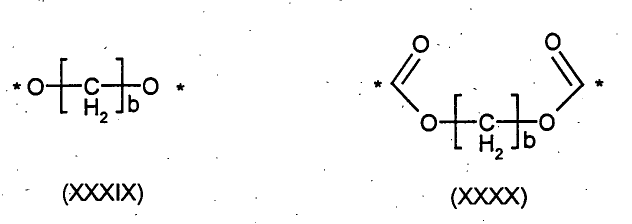 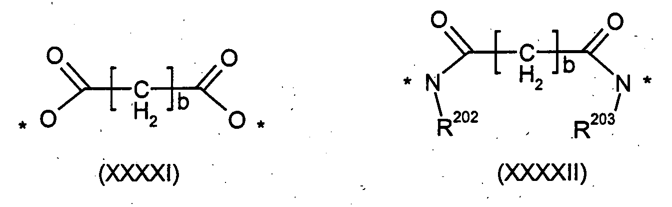 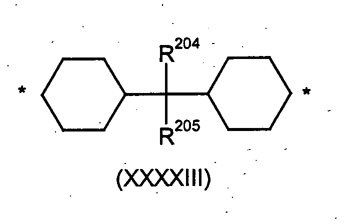 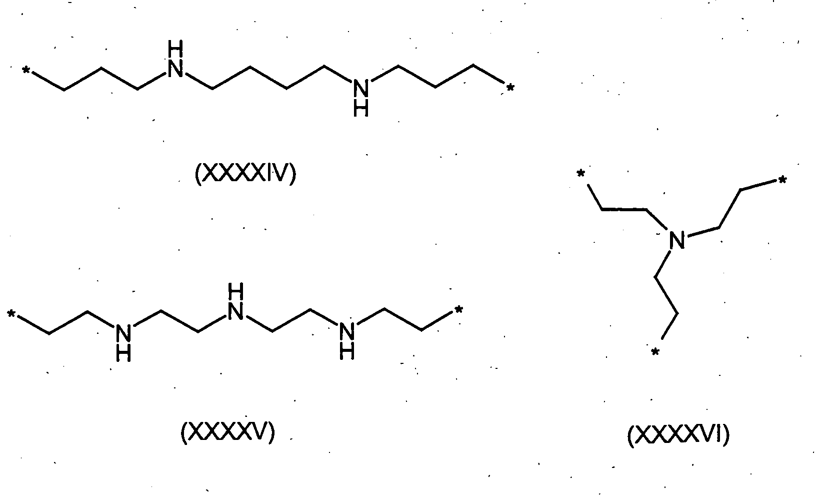 wobei
b für eine ganze Zahl von 2 bis 300,
R¹⁹⁸ - R²⁰⁵ gleich oder verschieden sind und unabhängig voneinander für H oder lineares oder verzweigtes C₁-C₃₀-Alkyl stehen, und
Ar¹ für gegebenenfalls durch eine lineare oder verzweigte C₁-C₃₀-Alkyl- oder C₁-C₃₀-Alkoxygruppe, F, Cyano oder CF₃- substituiertes Phenyl, Thienyl, Fluroenyl, Pyrrol, Carbazol oder 1,4-Phenylen-vinylen steht,
oder
X_{L} für α,ω-Alkyl, α,ω-Oligoethylenoxy, α,ω-Arylen, α,ω-Oligoester, α,ω-Oligoether, α,ω-Dioxyalkyl, α,ω-Dioxy-Poly- und α,ω-Dioxy-Oligoester oder die entsprechenden Polyacrylat-, Polyester-, Polyether-Polyole (Desmophene®, Firma Bayer AG, Leverkusen), oder für lineare und verzweigte aliphatische α,ω-Polycarbonat-Polyester steht,
wobei X_{L} an H_{L} gegebenenfalls über eine Ester-, Ether-, Amid-, Amin-, Imin-, Carbonat- oder Urethan-Gruppe angeknüpft ist.

4. Mehrkernige Metallkomplexe gemäß wenigstens einem der Ansprüche 1 bis 3, **dadurch gekennzeichnet, dass**
Me für ein Übergangsmetall der 6. bis 8. Nebengruppe, der Lanthanoid- oder Actionoidgruppe steht,
n gleich 2 oder 3 ist und
L, H_{L} und X_{L} die in Anspruch 1 oder 2 genannte Bedeutung haben,

5. Mehrkernige Metallkomplexe gemäß wenigstens einem der Ansprüche 1 bis 4, **dadurch gekennzeichnet, dass** sie ausgewählt sind aus den allgemeinen Strukturen (Ia) bis (Ih) 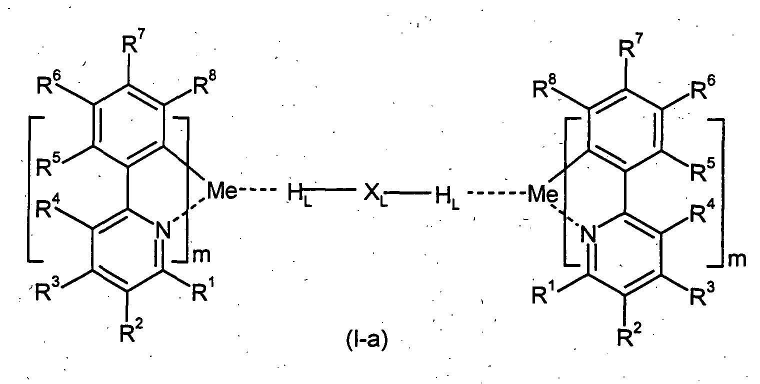 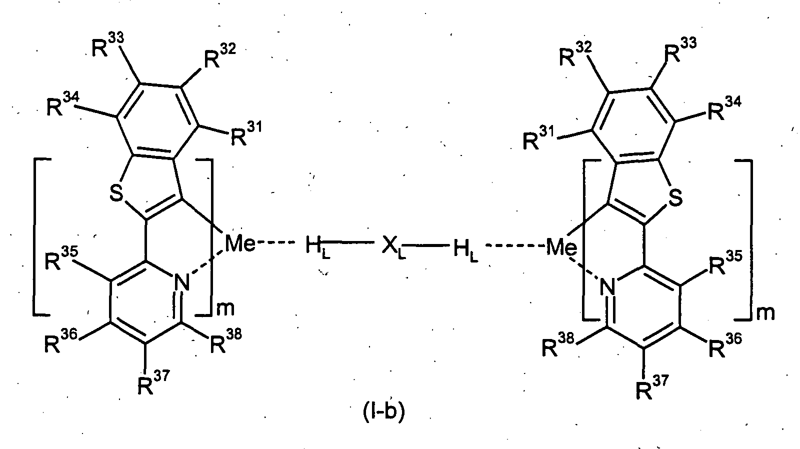 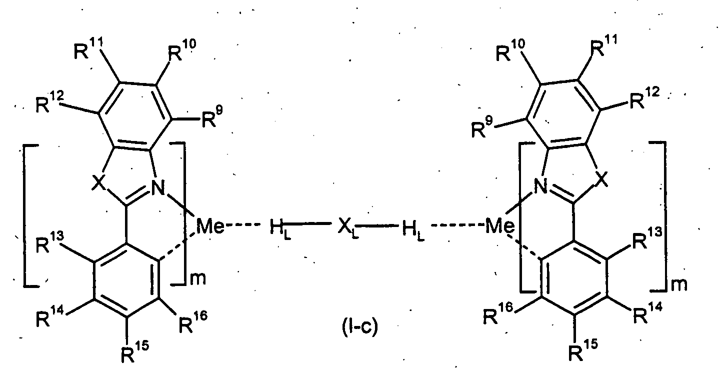 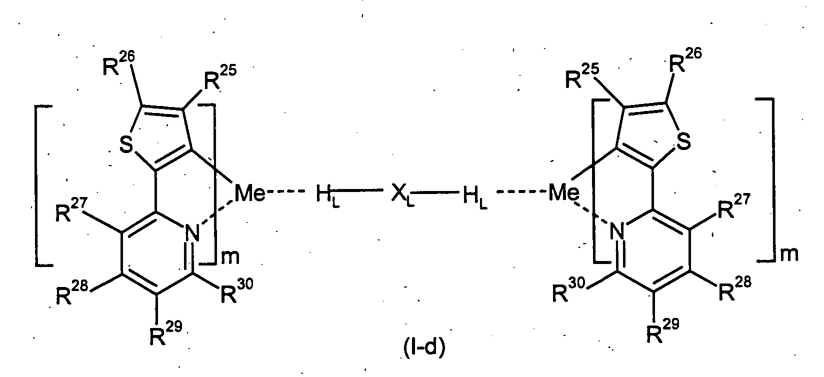 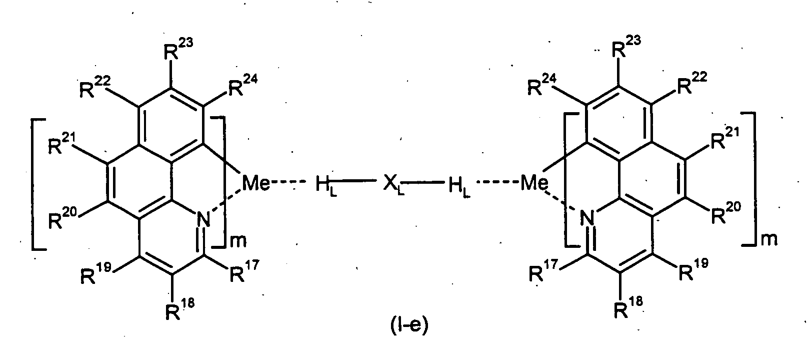 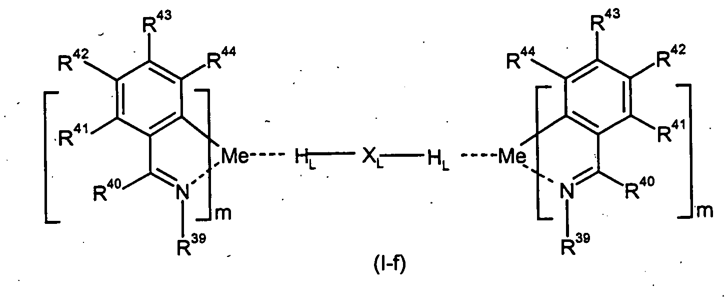 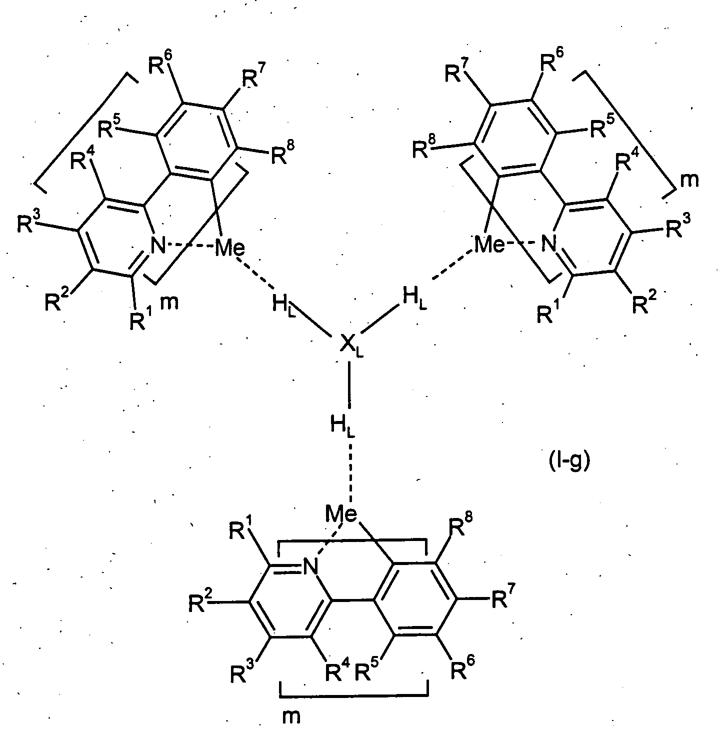 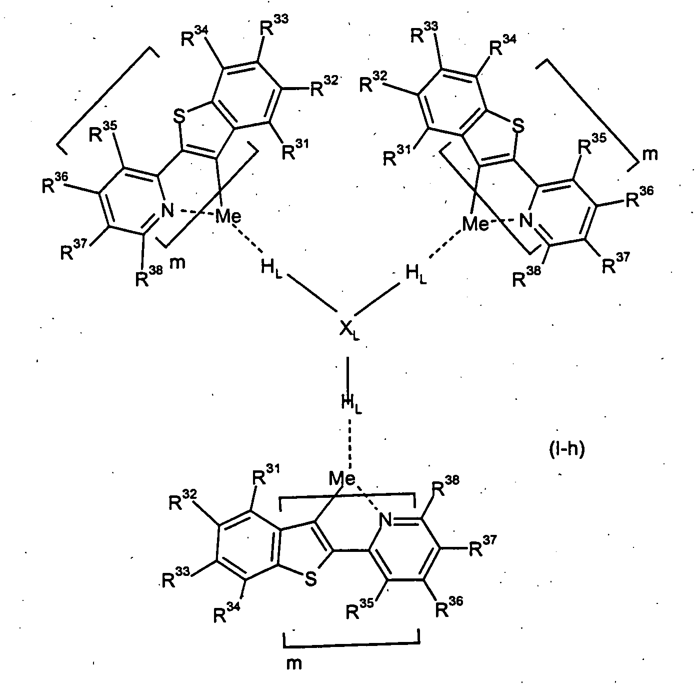 wobei
Me für Platin(II) oder Iridium(III) steht,
m für 1 oder 2 steht und
X, R¹ - R⁴⁴, H_{L} und X_{L} die in wenigstens einem der Ansprüche 1 bis 4 genannte Bedeutung haben.

6. Verfahren zur Herstellung mehrkerniger Metallkomplexe gemäß wenigstens einem der Ansprüche 1 bis 4, **dadurch gekennzeichnet, dass** Verbindungen der allgemeinen Formel (A) 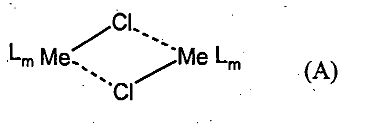 mit einem n-funktionellen Liganden X_{L}(H_{L})ₙ, enthaltend n jeweils bidentale Hilfsliganden H_{L}, unter Zusatz einer Base umgesetzt werden,
wobei m, Me, L, X_{L}, HL und n die in wenigstens einem der Ansprüche 1 bis 5 genannte Bedeutung haben.

7. Verfahren gemäß Anspruch 6, **dadurch gekennzeichnet, dass**
Me für Platin(II) oder Iridium(III) steht,
m für 1 oder 2 steht und
als Base Na₂CO₃, K₂CO₃ oder Natriummethanolat zugesetzt wird.

8. Verwendung der mehrkernigen Metallkomplexe gemäß wenigstens einem der Ansprüche 1 bis 5 als Phosphoreszenzemitter in lichtemittierenden Bauteilen.

9. Elektrolumineszierende Schichtanordnung enthaltend eine oder mehrere Schichten ausgewählt aus der Reihe der lochinjizierenden, lochleitenden, lichtemittierenden, löcherblockierenden, elektronentransportierenden oder elektroneninjizierenden Schichten, **dadurch gekennzeichnet, dass** die lichtemittierende Schicht mehrkernige Metallkomplexe gemäß wenigstens einem der Ansprüche 1 bis 5 als Phosphoreszenzemitter enthält.

10. Elektrolumineszierende Schichtanordnung gemäß Anspruch 9, **dadurch gekennzeichnet, dass** die mehrkernigen Metallkomplexe als Dotierstoffe in eine niedermolekulare oder polymere Matrix oder in eine solche Matrix aufgebaut aus niedermolekularen und polymeren Komponenten eingebettet sind.

11. Elektrolumineszierende Schichtanordnung gemäß Anspruch 10, **dadurch gekennzeichnet, dass** die mehrkernigen Metallkomplexe in der Matrix mit 0,1 bis 30,0 Gewichtsprozent enthalten sind.

12. Elektrolumineszierende Schichtanordnung gemäß Anspruch 10 oder 11, **dadurch gekennzeichnet, dass** die Matrix, für den Fall, dass sie polymer ist, auf Basis von Poly-*N*-vinylcarbazolen (PVK); Poly-2,7-fluorenen (PF), Poly-*para*-Phenylenen (PPP), 4,4'-N,N'-dicarbazolbiphenyl (CBP) öder einer Mischung aus wenigstens einem dieser Polymere und 2-(4-biphenylyl)-5-(4-tert-butylphenyl)-1,3,4-oxadiazol (PBD) aufgebaut ist, oder, für den Fall, dass sie niedermolekular ist, aus 4,4'-N,N'-dicarbazolbiphenyl (CBP) oder aus einem lochleitenden Material auf Basis von aromatischen tertiären Aminen aufgebaut ist, oder aus einer Mischung dieser Verbindungen_ mit 2-(4-biphenylyl)-5-(4-tert-butylphenyl)-1,3,4-oxadiazol (PBD) aufgebaut ist.

13. Elektrolumineszierende Schichtanordnung gemäß wenigstens einem der Ansprüche 9 bis 12, **dadurch gekennzeichnet, dass** die löcherblockierende Schicht aus 2,9-dimethyl-4,7-diphenyl-[1,10]phenanthrolin (BCP, Bathocuproin), Bis(2-methyl-8-hydroxyquinolinato)gallium-chlorid (Ga(qa)₂Cl), Ga(qa)₂F, Ga(qa)₂-O-Ga(qa)₂ oder 3-(4-Biphenylyl)-4-phenyl-5-tert-butyl-phenyl-1,2,4-triazol (TAZ), besteht.

14. Elektrolumineszierende Schichtanordnung gemäß wenigstens einem der Ansprüche 9 bis 13, **dadurch gekennzeichnet, dass** die lochinjizierende Schicht ein kationisches Polythiophen der allgemeinen Formel (B) enthält, 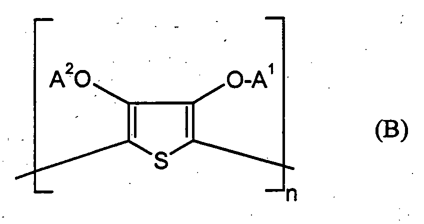 worin
A¹ und A² unabhängig voneinander für gegebenenfalls substituiertes (C₁-C₁₈)-Alkyl stehen oder zusammen gegebenenfalls substituiertes (C₁-C₁₈)-Alkylen bilden, und
n für eine ganze Zahl von 2 bis 10 000, vorzugsweise 3 bis 5 000 steht.

15. Elektrolumineszierende Schichtanordnung gemäß wenigstens einem der Ansprüche 9 bis 14, **dadurch gekennzeichnet, dass** die lochleitende Schicht ein aromatisches Amin der Formel (C) enthält, 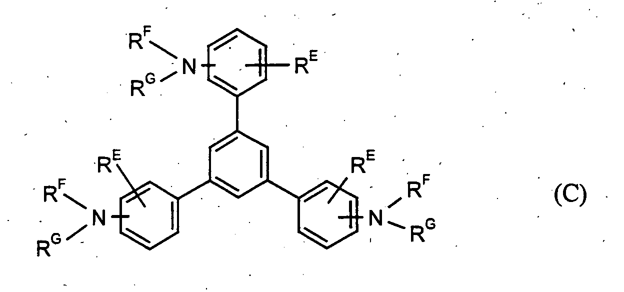 worin
R^{E} für Wasserstoff, gegebenenfalls substituiertes Alkyl oder Halogen steht und
R^{F} und R^{G} unabhängig voneinander für gegebenenfalls substituiertes (C₁-C₁₀)-Alkyl, Alkoxycarbonyl-substituiertes (C₁-C₁₀)-Alkyl, jeweils gegebenenfalls substituiertes Aryl, Alkyl oder Cycloalkyl stehen.

16. Elektrolumineszierende Schichtanordnung gemäß wenigstens einem der Ansprüche 9 bis 15 enthaltend, **dadurch gekennzeichnet, dass** die elektronentransportierende Schicht einen Galliumkomplex aus der Gruppe Ga(qa)₂-OR^{H}, Ga(qa)₂-OCOR^{H}, oder Ga(qa)₂-O-Ga(qa)₂ enthält, wobei
R^{H} für substituiertes oder unsubstituiertes Alkyl, Alkenyl, Aryl, Arylalkyl oder Cycloalkyl und 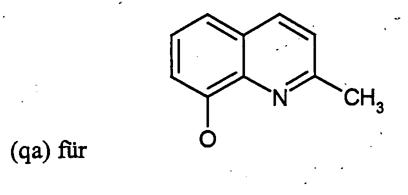 steht.

17. Verfahren zur Herstellung elektrolumineszierender Schichtanordnungen gemäß wenigstens einem der Ansprüche 9 bis 16, **dadurch gekennzeichnet, dass** die die mehrkernigen Metallkomplexe gemäß wenigstens einem der Ansprüche 1 bis 5 enthaltende lichtemittierende Schicht aus Lösung aufgebracht wird.

18. Verfahren zur Herstellung elektrolumineszierender Schichtanordnungen gemäß wenigstens einem der Ansprüche 10 bis 16, **dadurch gekennzeichnet, dass** die mehrkernigen Metallkomplexe gemäß wenigstens einem der Ansprüche 1 bis 5 zusammen mit der Matrix aus Lösung aufgebracht werden.

19. Lichtemittiernde Bauteile, **dadurch gekennzeichnet, dass** sie eine erfindungsgemäße elektrolumineszierende Schichtanordnung gemäß wenigstens einem der Ansprüche 9 bis 16 enthalten.
